# EUROPEAN PATENT APPLICATION

(11) **EP 3 819 956 A1**
(43) Date of publication of application: **12.05.2021**
(21) Application number: 19830556.7
(22) Date of filing: 04.07.2019
(51) Int. Cl.: H01L 51/50, H05B 33/10

(54) **COMPOSITION FOR FORMING CHARGE-TRANSPORTING THIN FILM**

(30) Priority: 05.07.2018 JP 2018127980
(71) Applicant: Nissan Chemical Corporation, Tokyo 103-6119 (JP)
(72) Inventor: ENDO, Toshiyuki, Funabashi-shi, Chiba 274-0052 (JP); OTA, Hirofumi, Funabashi-shi, Chiba 274-0052 (JP)
(74) Representative: Mewburn Ellis LLP
(86) International application number: PCT/JP2019/026611
(87) International publication number: WO 2020/009184

(57) **Abstract**

This composition for forming a charge-transporting thin film, which contains an organic solvent and a charge-transporting substance precursor that has a 9-t-butoxycarbonyl carbazole structure in the molecule, yields a thin film that exhibits excellent charge transport properties even when firing is performed at a low temperature. As pertains to the charge-transporting substance precursor, the composition can be prepared using a low-polarity solvent that causes less damage to a substrate or a member comprising an organic compound than is the case with a high-polarity amide-based solvent, etc.

## Description

### TECHNICAL FIELD

The present invention relates to a composition for forming a charge-transporting thin film.

### BACKGROUND ART

A charge-transporting thin film made of an organic compound is used as the light emitting layer or the charge injection layer in electronic devices, particularly in organic electroluminescence (hereinafter referred to as organic EL) devices. In particular, the hole injection layer is responsible for the transfer and receipt of electric charges between the anode and the hole transport layer or the light emitting layer, and plays an important function for achieving low voltage drive and high luminance of organic EL devices.

The methods for forming the hole injection layer are roughly classified into a dry process represented by a vapor deposition method and a wet process represented by a spin coating method. Comparing these processes to each other, the wet process can efficiently produce a thin film having high flatness over a large area. Accordingly, at the present time when the area of an organic EL display is being increased, a hole injection layer formable by a wet process is desired.

In view of these circumstances, the present inventors have been developing charge-transporting materials that are applicable to various wet processes and provide a thin film that can achieve excellent EL device characteristics when applied to the hole injection layer of organic EL devices, and compounds used for them having good solubility in an organic solvent (see, for example, Patent Documents 1 to 4).

In addition, in the field of organic ELs in recent years, due to the trend of reducing the weight of devices and making them thin and flexible, substrates and members made of organic compounds have come to be used instead of glass substrates. Therefore, there is a need for a composition that can be baked at a lower temperature than that for conventional products, or can be prepared using an organic solvent that causes less damage to such substrates and members, and gives a thin film having good charge transportability even in that case.

### PRIOR ART DOCUMENTS

### PATENT DOCUMENTS

Patent Document 1: WO 2008/067276
Patent Document 2: WO 2008/129947
Patent Document 3: WO 2006/025342
Patent Document 4: WO 2010/058777
Patent Document 5: WO 2006/025290
Patent Document 6: JP-A 2012-236777

### NON-PATENT DOCUMENT

Non-Patent Document 1: Advanced Functional Materials (2013), 23 (5), 619-628.

### SUMMARY OF INVENTION

### TECHNICAL PROBLEM

The present invention has been made in view of the above circumstances, and have an object to provide a composition for forming a charge-transporting thin film, by which composition even when baked at a low temperature, the obtained thin film exhibits good charge transportability, or which composition can be prepared using a low-polarity solvent that causes less damage to a substrate or a member made of an organic compound, as compared with a high-polarity amide-based solvent or the like, and which composition provides a charge-transporting thin film capable of achieving an organic EL device having excellent luminance characteristics when used as the hole injection layer.

### SOLUTION TO PROBLEM

As a result of diligent studies to achieve the above object, the present inventors have found that a charge-transporting substance precursor having a 9-t-butoxycarbonyl carbazole structure in the molecule has excellent solubility in a low-polarity solvent, a thin film obtained from a composition for forming a charge-transporting thin film containing the charge-transporting substance precursor exhibits good charge transportability even when baked at a low temperature, and excellent device characteristics can be achieved when the thin film is applied to an organic EL device, leading to completion of this invention.

In the present invention, "baking at a low temperature" means "baking at a temperature of 200°C or lower".

In addition, for example, although Patent Documents 5 and 6, and Non-Patent Document 1 disclose compounds in which the 9-position (N-position) of carbazole is protected by a t-butoxycarbonyl group as an intermediate, neither document discloses a composition for forming a charge-transporting thin film containing a charge-transporting substance precursor having a 9-t-butoxycarbonyl carbazole structure in the molecule and an organic solvent.

That is, the present invention provides
1. A composition for forming a charge-transporting thin film, including: a charge-transporting substance precursor having in its molecule a 9-t-butoxycarbonyl carbazole structure; and an organic solvent,
2. The composition for forming a charge-transporting thin film of item 1, further including a dopant substance,
3. A charge-transporting thin film, obtained from the composition for forming a charge-transporting thin film of item 1 or 2,
4. An electronic device having the charge-transporting thin film of item 3,
5. An organic electroluminescence device having the charge-transporting thin film of item 3,
6. The organic electroluminescence device of item 5, wherein the charge-transporting thin film is a hole injection layer or a hole transport layer,
7. A method for producing a charge-transporting thin film, the method including applying the composition for forming a charge-transporting thin film of item 1 or 2 on a substrate, and baking the composition to desorb a 9-t-butoxycarbonyl group from the charge-transporting substance precursor.

### ADVANTAGEOUS EFFECTS OF INVENTION

The charge-transporting substance precursor having a 9-t-butoxycarbonyl carbazole structure in the molecule used in the present invention can easily prepare a composition for forming a charge-transporting thin film by dissolution in a low-polarity solvent that causes less damage to a substrate or a member composed of an organic compound, as compared with a high-polarity amide-based solvent, etc. In addition, using the charge-transporting substance precursor, the composition for forming a charge-transporting thin film can be easily prepared by dissolution in such a solvent, even together with a dopant substance. In addition, a thin film produced from the composition for forming a charge-transporting thin film of the present invention exhibits good charge transportability when baked not only at a high temperature but also at a low temperature.

Such a charge-transporting thin film obtained from the composition for forming a charge-transporting thin film of the present invention can be suitably used as a thin film for an electronic device such as an organic EL device. In particular, by using the charge-transporting thin film of the present invention as the hole injection layer, an organic EL device having excellent luminance characteristics can be obtained.

In addition, the composition for forming a charge-transporting thin film of the present invention can fully cope with recent developments in the field of organic EL devices, because even when various wet processes that can form a thin film over a large area, such as a slit coating method and an inkjet method, are used, a thin film having excellent charge transportability can be produced with good reproducibility.

### DESCRIPTION OF EMBODIMENTS

Hereinafter, the present invention is described in more detail.

The composition for forming a charge-transporting thin film of the present invention contains a charge-transporting substance precursor having a 9-t-butoxycarbonyl carbazole structure in the molecule.

Here, in the present invention, charge transportability is synonymous with conductivity, and is also synonymous with hole transportability. The charge-transporting substance is a substance which imparts charge transportability to a solid film obtained by using a composition for forming a charge-transporting thin film, which substance may have charge transportability in itself, or may have charge transportability when used together with a charge-accepting substance (also referred to as a dopant substance). The charge-transporting substance precursor is a substance which, in the process of forming a composition for forming a charge-transporting thin film into a solid film by an external stimulus (for example, heat), becomes a charge-transporting substance having a different structure from that of the precursor (for example, the structure changes due to desorption of the protecting group in the molecule in the precursor), and as a result, develops or improves the charge transportability, thereby imparting the charge transportability to the solid film. The charge-transporting substance precursor and the charge-transporting substance obtained from the precursor may have charge transportability in themselves, or may exhibit charge transportability when used in combination with a charge-accepting substance.

In the present invention, the nitrogen atom at the 9-position of the carbazole structure is protected by a t-butoxycarbonyl group (hereinafter, also referred to as Boc group), so that as compared with the case of a carbazole structure having an exposed NH group which is not protected by a Boc group, for example, it is possible to increase the solubility in a low-polarity solvent such as toluene, and it is possible to yield a thin film having excellent charge transportability by applying on a substrate the composition for forming a charge-transporting thin film, which composition is obtained by dissolving in a solvent the charge-transporting substance precursor having a carbazole structure in the molecule in which the nitrogen atom at the 9-position is protected by a Boc group, and baking the composition to desorb the Boc group, thereby exposing the NH group.

The charge-transporting substance precursor used in the present invention is not particularly limited as long as it has a 9-t-butoxycarbonyl carbazole structure, and typically includes charge-transporting oligomer compounds and charge-transporting polymer compounds (linear type, dendrimer type) having a repeating unit such as a fluorene skeleton (including a spirofluorene skeleton), including an aniline skeleton, a thiophene skeleton, a pyrrole skeleton and a carbazole skeleton (indrocarbazole skeleton) in which a 9-t-butoxycarbonyl carbazole structure is contained.

In such charge-transporting oligomeric compounds and charge-transporting polymer compounds, the 9-t-butoxycarbonyl carbazole structure may be present at the end of the molecule, the place other than other than the end, or both. For example, in the case of an oligomer or polymer having a repeating structure, the repeating structure may be contained in the main chain, and if there is a side chain, the repeating structure may be present in the side chain.

In addition, not all 9-t-butoxycarbonyl carbazole structures need to be equivalent. For example, some may have a substituent on the rings composing the carbazole structure, and others may not have a substituent on the rings composing the carbazole structure. In addition, for example, some may share the benzene ring composing the carbazole structure with another structure, and others may not share the benzene ring composing the carbazole structure with another structure.

Furthermore, the 9-t-butoxycarbonyl carbazole structure may be randomly present in the charge-transporting compound or may be unevenly distributed as a block.

When the charge-transporting substance precursor used in the present invention has two or more 9-t-butoxycarbonyl carbazole structures, the two or more such structures may share the benzene ring in those structures.

In addition, the number of 9-t-butoxycarbonyl carbazole structures in the charge-transporting substance precursor used in the present invention varies depending on the molecular structure and the molecular weight, and thus cannot be unconditionally specified, but is usually 1 to 1,000.

When the charge-transporting substance precursor used in the present invention is a charge-transporting oligomer compound, its molecular weight is usually 200-5,000, but from the viewpoint of suppressing sublimation during baking and improving charge transportability, it is preferably 300 or more, more preferably 500 or more, even more preferably 700 or more, still more preferably 1,000 or more, and from the viewpoint of ensuring good solubility in an organic solvent, it is preferably 4,500 or less, more preferably 4,000 or less, even more preferably 3,500 or less, still more preferably 3,000 or less.

In addition, when the charge-transporting substance precursor used in the present invention is a charge-transporting polymer compound, its weight average molecular weight is usually 6,000-200,000, but from the viewpoint of improving charge transportability, it is preferably 7,000 or more, more preferably 8,000 or more, even more preferably 9,000 or more, still more preferably 10,000 or more, and from the viewpoint of ensuring good solubility in an organic solvent, it is preferably 150,000 or less, more preferably 100,000 or less, still more preferably 75,000 or less.

In the present invention, the weight average molecular weight is an average molecular weight obtained in terms of standard polystyrene by gel permeation chromatography (GPC) analysis.

In particular, when the charge-transporting substance precursor used in the present invention is a charge-transporting oligomer compound including a partial structure represented by the following formula (M2), from the viewpoint of balance between the charge transportability, the solubility of precursor in an organic solvent, the handleability, and the like, the number of 9-t-butoxycarbonyl carbazole structures in the precursor is usually 2 or more and 100 or less, preferably 75 or less, more preferably 50 or less.

A preferable example of the charge-transporting substance precursor used in the present invention includes, but is not limited to, a charge-transporting substance precursor including a partial structure represented by the following formula (M1).

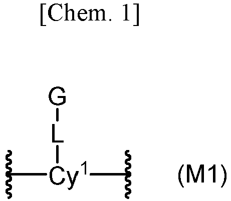

In the formula, G is a univalent group represented by the following formula (G1), and from the viewpoint of enhancement of the charge transportability and from the viewpoint of availability of raw material compounds, a group represented by the formula (G'1-1) or formula (G'1-2) is preferable.

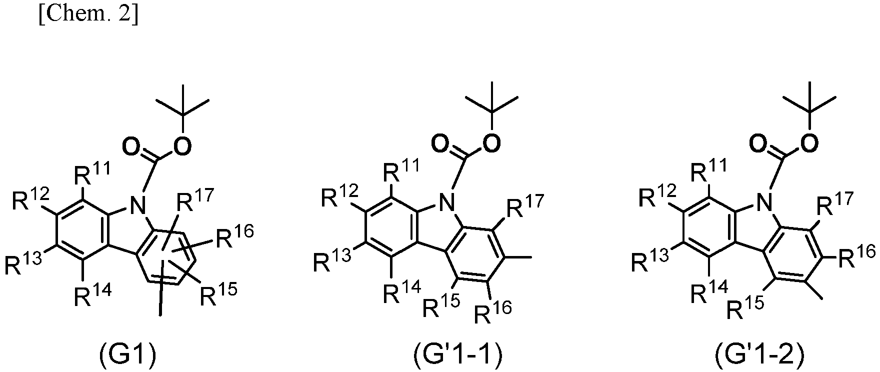

In the formula, R¹¹ to R¹⁷ each independently represent a hydrogen atom, a halogen atom, a nitro group, a cyano group, or a diphenylamino group, a C1-20 alkyl group, a C2-20 alkenyl group, a C2-20 alkynyl group, a C6-20 aryl group or a C2-20 heteroaryl group that may be substituted with a halogen atom.

The halogen atom includes a fluorine atom, a chlorine atom, a bromine atom and an iodine atom, but a fluorine atom is preferable.

The C1-20 alkyl group may be linear, branched or cyclic. Examples of the C1-20 alkyl group include C1-20 linear or branched alkyl groups such as a methyl group, an ethyl group, an n-propyl group, an isopropyl group, an n-butyl group, an isobutyl group, an s-butyl group, a t-butyl group, an n-pentyl group, an n-hexyl group, an n-heptyl group, an n-octyl group, an n-nonyl group and an n-decyl group; and C3-20 cyclic alkyl groups such as a cyclopropyl group, a cyclobutyl group, a cyclopentyl group, a cyclohexyl group, a cycloheptyl group, a cyclooctyl group, a cyclononyl group, a cyclodecyl group, a bicyclobutyl group, a bicyclopentyl group, a bicyclohexyl group, a bicycloheptyl group, a bicyclooctyl group, a bicyclononyl group and a bicyclodecyl group.

Specific examples of the C2-20 alkenyl group include an ethenyl group, an n-1-propenyl group, an n-2-propenyl group, a 1-methylethenyl group, an n-1-butenyl group, an n-2-butenyl group, an n-3-butenyl group, a 2-methyl-1-propenyl group, a 2-methyl-2-propenyl group, a 1-ethylethenyl group, a 1-methyl-1-propenyl group, a 1-methyl-2-propenyl group, an n-1-pentenyl group, an n-1-decenyl group and an n-1-eicosenyl group.

Specific examples of the C2-20 alkynyl group include an ethynyl group, an n-1-propynyl group, an n-2-propynyl group, an n-1-butynyl group, an n-2-butynyl group, an n-3-butynyl group, a 1-methyl-2-propynyl group, an n-1-pentynyl group, an n-2-pentynyl group, an n-3-pentynyl group, an n-4-pentynyl group, a 1-methyl-n-butynyl group, a 2-methyl-n-butynyl group, a 3-methyl-n-butynyl group, a 1,1-dimethyl-n-propynyl group, an n-1-hexynyl group, an n-1-decynyl group, an n-1-pentadecynyl group and an n-1-eicosynyl group.

Specific examples of the C6-20 aryl group include a phenyl group, a 1-naphthyl group, a 2-naphthyl group, a 1-anthryl group, a 2-anthryl group, a 9-anthryl group, a 1-phenanthryl group, a 2-phenantril group, a 3-phenantril group, a 4-phenantril group and a 9-phenantril group.

Specific examples of the C2-20 heteroaryl group include a 2-thienyl group, a 3-thienyl group, a 2-pyridyl group, a 3-pyridyl group and a 4-pyridyl group.

In particular, R¹¹ to R¹⁷ are preferably a hydrogen atom, a fluorine atom, a cyano group, a C1-20 alkyl group which may be substituted with a halogen atom, a C6-20 aryl group which may be substituted with a halogen atom and a C2-20 heteroaryl group which may be substituted with a halogen atom, more preferably a hydrogen atom, a fluorine atom, a cyano group, a C1-10 alkyl group which may be substituted with a halogen atom and a phenyl group which may be substituted with a halogen atom, even more preferably a hydrogen atom, a fluorine atom, a methyl group and a trifluoromethyl group, optimally all hydrogen atoms.

In the formula, L represents a single bond, or represents a C1-20 bivalent aliphatic hydrocarbon group, a C6-20 bivalent aromatic hydrocarbon group or a C2-20 bivalent heteroaromatic hydrocarbon group, in which these groups may be substituted with a substituent.

Cy¹ is a skeleton containing an aromatic ring or a heteroaromatic ring such as a benzene skeleton, a naphthalene skeleton, an anthracene skeleton, a pyrene skeleton, a thiophene skeleton, a furan skeleton, a pyrrole skeleton, a benzothiophene skeleton, a benzofuran skeleton, a benzopyrrole skeleton, a dibenzothiophene skeleton, a dibenzofuran skeleton, a carbazole skeleton, a fluorene skeleton, a spirofluorene skeleton, a triarylamine skeleton, a diarylamine skeleton, a monoarylamine skeleton, a thienothiophene skeleton, a thienobenzothiophene skeleton and an indolocarbazole skeleton, to which an -L-G group is bonded in place of the hydrogen atom present on the aromatic ring or heteroaromatic ring or the hydrogen atom on the amine contained in the skeleton. In addition, these skeletons may have a substituent other than the -L-G group.

A more suitable embodiment of the charge-transporting substance precursor of the present invention includes, but is not limited to, a charge-transporting substance precursor including a partial structure represented by the following formula (M2).

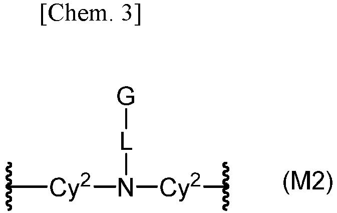

In the formula, Cy²s each independently represent a C6-20 aromatic hydrocarbon skeleton such as a benzene ring or a naphthalene ring, and the two Cy²s may be bonded to each other to form a ring. In addition, the aromatic hydrocarbon skeleton may have a substituent.
G and L have the same meaning as described above.

From the viewpoint of charge transportability, the charge-transporting substance precursor including the partial structure represented by the formula (M2) may further contain in the molecule at least one of groups represented by any of the following formulas (G2) to (G16) in addition to the group represented by the formula (G1).

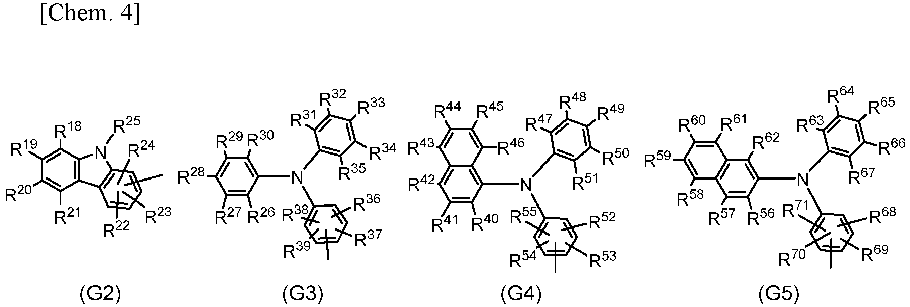

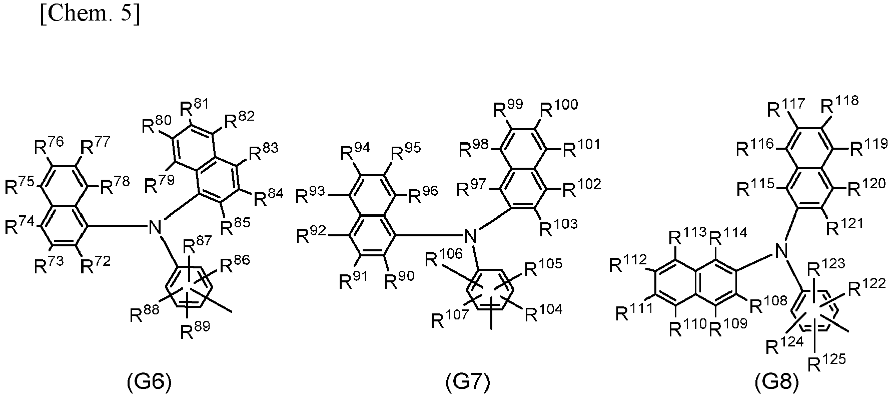

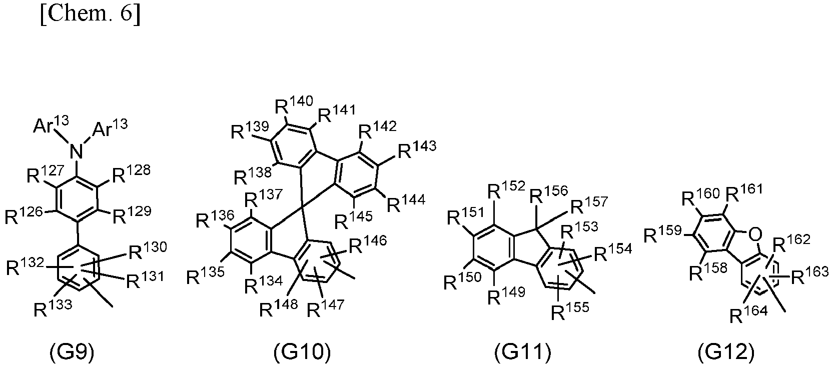

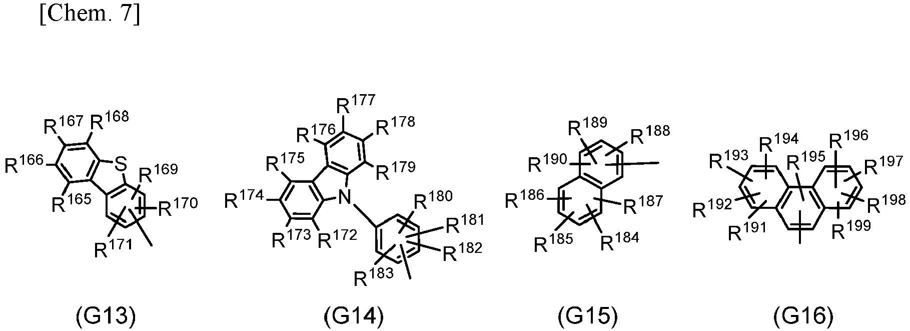

The group represented by any of the formulas (G2) to (G16) is preferably a group represented by any of the following formulas (G'2-1) to (G'16-5) from the viewpoint of easy availability of raw material compounds, easy synthesis of the precursor, etc.

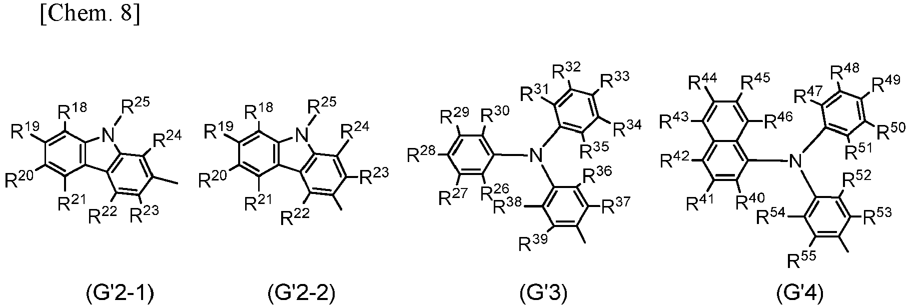

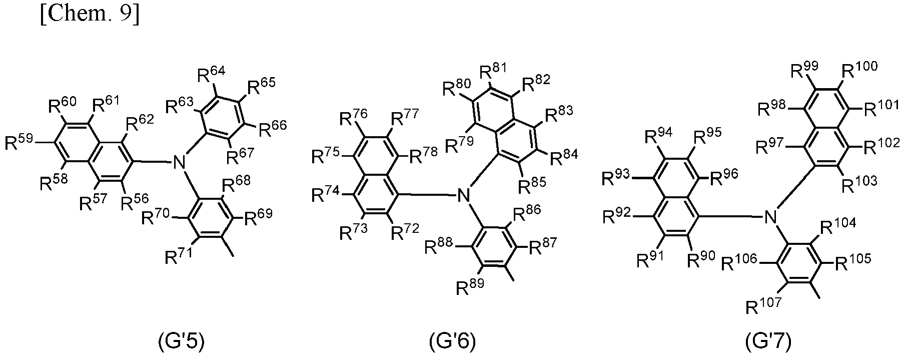

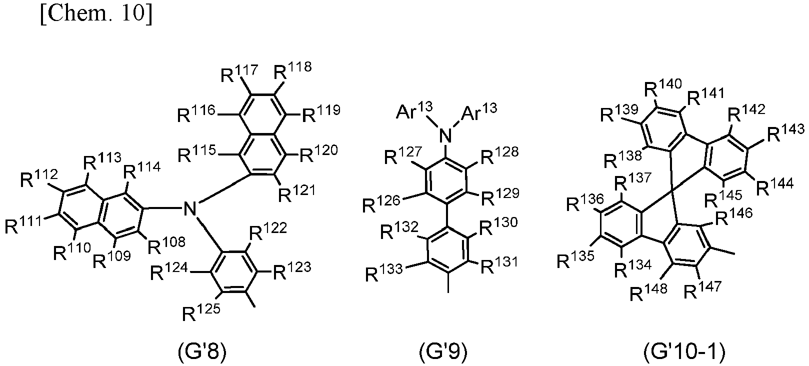

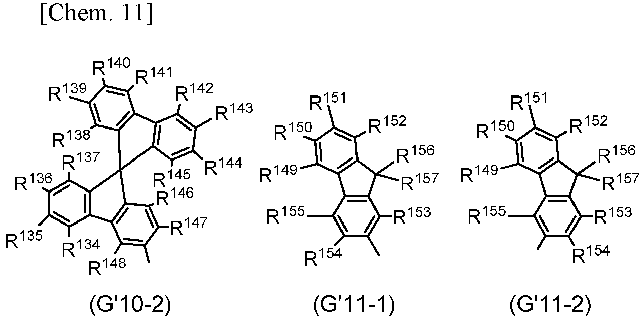

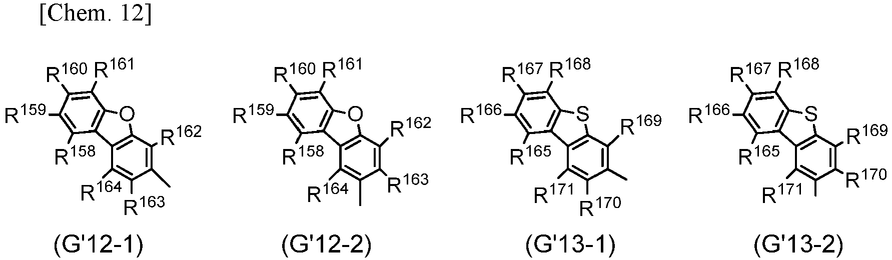

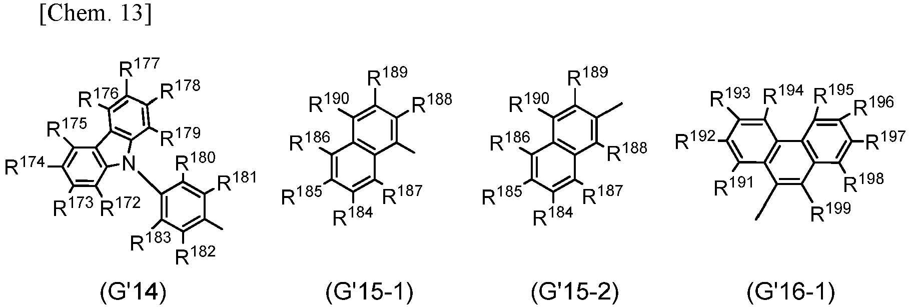

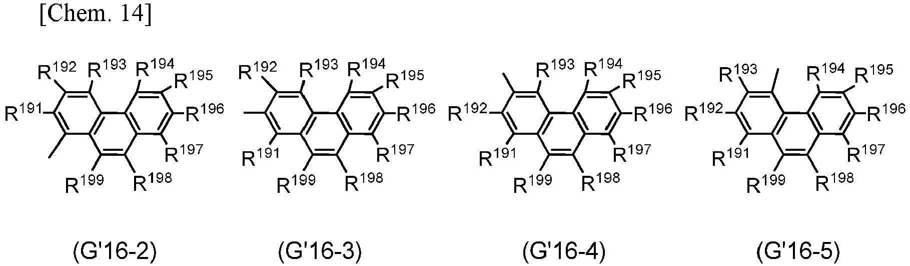

Here, R¹⁸ to R²⁴, R²⁶ to R¹⁵⁵ and R¹⁵⁸ to R¹⁹⁹ each independently represent a hydrogen atom, a halogen atom, a nitro group, a cyano group, or a diphenylamino group, a C1-20 alkyl group, a C2-20 alkenyl group, a C2-20 alkynyl group, a C6-20 aryl group or a C2-20 heteroaryl group which may be substituted with a halogen atom, R¹⁵⁶ and R¹⁵⁷ each independently represent a C6-20 aryl group or a C2-20 heteroaryl group which may be substituted with Z¹, R²⁵ represents a hydrogen atom, a C1-20 alkyl group, a C2-20 alkenyl group or a C2-20 alkynyl group which may be substituted with Z⁴, or a C6-20 aryl group or a C2-20 heteroaryl group which may be substituted with Z¹, in which Z¹ represents a halogen atom, a nitro group, a cyano group, or a C1-20 alkyl group, a C2-20 alkenyl group or a C2-20 alkynyl group which may be substituted with Z², in which Z² represents a halogen atom, a nitro group, a cyano group or a C6-20 aryl group or a C2-20 heteroaryl group which may be substituted with Z³, in which Z³ represents a halogen atom, a nitro group or a cyano group, and Z⁴ represents a halogen atom, a nitro group, a cyano group, or a C6-20 aryl group or a C2-20 heteroaryl group which may be substituted with Z⁵, in which Z⁵ represents a halogen atom, a nitro group, a cyano group, or a C1-20 alkyl group, a C2-20 alkenyl group or a C2-20 alkynyl group which may be substituted with Z³. Specific examples of the halogen atom, C1-20 alkyl group, C2-20 alkenyl group, C2-20 alkynyl group, C6-20 aryl group and C2-20 heteroaryl group include the same as those described in R¹¹ to R¹⁷ above.

In particular, R¹⁸ to R²⁴, R²⁶ to R¹⁵⁵ and R¹⁵⁸ to R¹⁹⁹ are preferably a hydrogen atom, a fluorine atom, a cyano group, a diphenylamino group which may be substituted with a halogen atom, a C1-20 alkyl group which may be substituted with a halogen atom, a C6-20 aryl group which may be substituted with a halogen atom or a C2-20 heteroaryl group which may be substituted with a halogen atom, more preferably a hydrogen atom, a fluorine atom, a cyano group, a C1-10 alkyl group which may be substituted with a halogen atom or a phenyl group which may be substituted with a halogen atom, even more preferably a hydrogen atom, a fluorine atom, a methyl group or a trifluoromethyl group, optimally a hydrogen atom.

In addition, R²⁵ is preferably a hydrogen atom, a C6-20 aryl group which may be substituted with Z¹, a C2-20 heteroaryl group which may be substituted with Z¹ or a C1-20 alkyl group which may be substituted with Z⁴, more preferably a hydrogen atom, a C6-14 aryl group which may be substituted with Z¹, a C2-14 heteroaryl group which may be substituted with Z¹ or a C1-10 alkyl group which may be substituted with Z⁴, even more preferably a hydrogen atom, a C6-14 aryl group which may be substituted with Z¹, a C2-14 nitrogen-containing heteroaryl group which may be substituted with Z¹ or a C1-10 alkyl group which may be substituted with Z⁴, still more preferably a hydrogen atom, a phenyl group which may be substituted with Z¹, a 1-naphthyl group which may be substituted with Z¹, a 2-naphthyl group which may be substituted with Z¹, a 2-pyridyl group which may be substituted with Z¹, a 3-pyridyl group which may be substituted with Z¹, a 4-pyridyl group which may be substituted with Z¹ or a methyl group which may be substituted with Z⁴.

R¹⁵⁶ and R¹⁵⁷ is preferably a C6-14 aryl group which may be substituted with Z¹ or a C2-14 heteroaryl group which may be substituted with Z¹, more preferably a C6-14 aryl group which may be substituted with Z¹, further preferably a phenyl group which may be substituted with Z¹, a 1-naphthyl group which may be substituted with Z¹ or a 2-naphthyl group which may be substituted with Z¹.

In addition, Ar¹³s each independently represent a C6-20 aryl group which may be substituted with a di(C6-20 aryl group) amino group. Specific examples of the C6-20 aryl group include the same as those described in R¹¹ to R¹⁷, and specific examples of the di(C6-20 aryl group) amino group include a diphenylamino group, a 1-naphthylphenylamino group, a di(1-naphthyl)amino group, a 1-naphthyl-2-naphthylamino group and a di(2-naphthyl)amino group.

Ar¹³ is preferably a phenyl group, a 1-naphthyl group, a 2-naphthyl group, a 1-anthryl group, a 2-anthryl group, a 9-anthryl group, a 1-phenanthryl group, a 2-phenanthryl group, a 3-phenyltril group, a 4-phenantril group, a 9-phenyltril group, a p-(diphenylamino)phenyl group, a p-(1-naphthylphenylamino)phenyl group, a p-(di(1-naphthyl)amino)phenyl group, a p-(1-naphthyl-2-naphthylamino)phenyl group or a p-(di(2-naphthyl)amino)phenyl group, more preferably a p-(diphenylamino)phenyl group.

In R²⁵, R¹⁵⁶ and R¹⁵⁷, Z¹ is preferably a halogen atom, a nitro group, a cyano group, a C1-10 alkyl group which may be substituted with Z², a C2-10 alkenyl group which may be substituted with Z² or a C2-10 alkynyl group which may be substituted with Z², more preferably a halogen atom, a nitro group, a cyano group, a C1-3 alkyl group which may be substituted with Z², a C2-3 alkenyl group which may be substituted with Z² or a C2-3 alkynyl group which may be substituted with Z², even more preferably a fluorine atom, a C1-3 alkyl group which may be substituted with Z², a C2-3 alkenyl group which may be substituted with Z² or a C2-3 alkynyl group which may be substituted with Z².

In R²⁵, R¹⁵⁶ and R¹⁵⁷, Z⁴ is preferably a halogen atom, a nitro group, a cyano group or a C6-14 aryl group which may be substituted with Z⁵, more preferably a halogen atom, a nitro group, a cyano group or a C6-10 aryl group which may be substituted with Z⁵, even more preferably a fluorine atom or a C6-10 aryl group which may be substituted with Z⁵, still more preferably a fluorine atom or a phenyl group which may be substituted with Z⁵.

In R²⁵, R¹⁵⁶ and R¹⁵⁷, Z² is preferably a halogen atom, a nitro group, a cyano group or a C6-14 aryl group which may be substituted with Z³, more preferably a halogen atom, a nitro group, a cyano group or a C6-10 aryl group which may be substituted with Z³, even more preferably a fluorine atom or a C6-10 aryl group which may be substituted with Z³, still more preferably a fluorine atom or a phenyl group which may be substituted with Z³.

In R²⁵, R¹⁵⁶ and R¹⁵⁷, Z⁵ is preferably a halogen atom, a nitro group, a cyano group, a C1-10 alkyl group which may be substituted with Z3, a C2-10 alkenyl group which may be substituted with Z³ or a C2-10 alkynyl group which may be substituted with Z³, more preferably a halogen atom, a nitro group, a cyano group, a C1-3 alkyl group which may be substituted with Z³, a C2-3 alkenyl group which may be substituted with Z³ or a C2-3 alkynyl group which may be substituted with Z³, even more preferably a fluorine atom, a C1-3 alkyl group which may be substituted with Z³, a C2-3 alkenyl group which may be substituted with Z³ or a C2-3 alkynyl group which may be substituted with Z³.

In R²⁵, R¹⁵⁶ and R¹⁵⁷, Z³ is preferably a halogen atom, more preferably a fluorine atom.

In the present invention, specific examples of a group suitable for R²⁵ include, but are not limited to, the following groups.

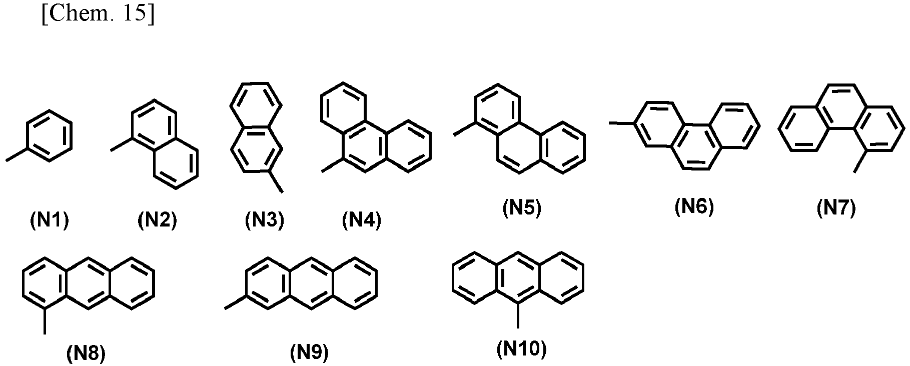

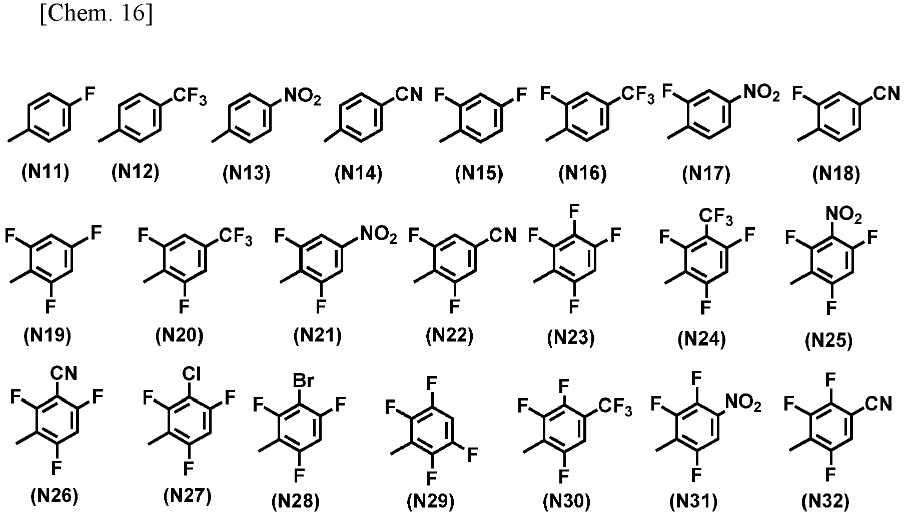

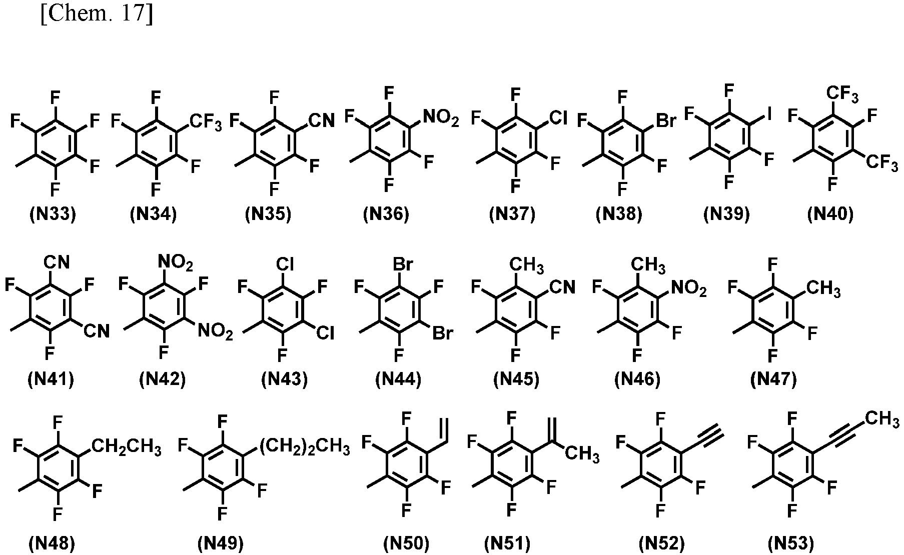

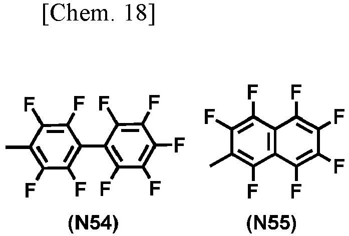

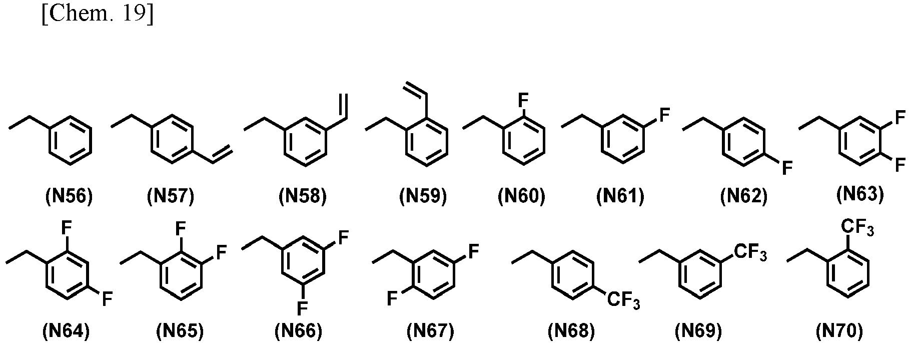

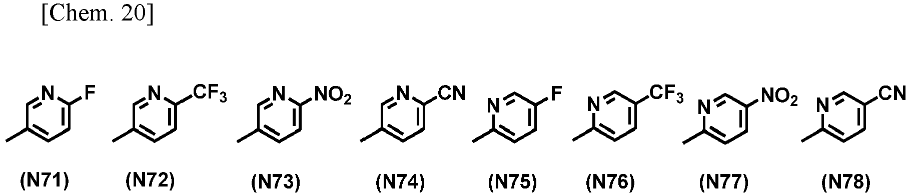

A suitable typical example of the charge-transporting substance precursor includes, but is not limited to, an aniline derivative represented by the following formula (1).

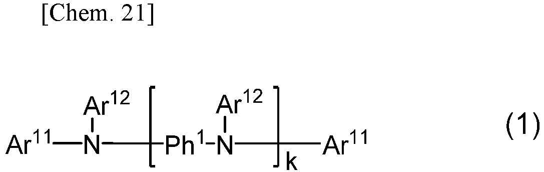

Ph¹ in the formula (1) represents a group represented by the formula (PI).

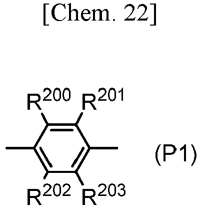

R²⁰⁰ to R²⁰³ each independently represent a hydrogen atom, a halogen atom, a nitro group, a cyano group, or a C1-20 alkyl group, a C2-20 alkenyl group, a C2-20 alkynyl group, a C6-20 aryl group or a C2-20 heteroaryl group which may be substituted with a halogen atom, specific examples of the halogen atom, C1-20 alkyl group, C2-20 alkenyl group, C2-20 alkynyl group, C6-20 aryl group and C2-20 heteroaryl group including the same as those described in R¹¹ to R¹⁷ above.

In particular, R²⁰⁰ to R²⁰³ are preferably a hydrogen atom, a fluorine atom, a cyano group, a C1-20 alkyl group which may be substituted with a halogen atom, a C6-20 aryl group which may be substituted with a halogen atom or a C2-20 heteroaryl group which may be substituted with a halogen atom, more preferably a hydrogen atom, a fluorine atom, a cyano group, a C1-10 alkyl group which may be substituted with a halogen atom or a phenyl group which may be substituted with a halogen atom, even more preferably a hydrogen atom, a fluorine atom, a methyl group or a trifluoromethyl group, optimally a hydrogen atom.

On the other hand, Ar¹¹ and Ar¹² in the formula (1) each independently represent a group represented by any of the formulas (G1) to (G16), but at least one of Ar¹¹ and Ar¹² represents a group represented by the formula (G1).

In addition, Ar¹¹ and Ar¹² preferably represent a group represented by any of the formulas (G'1-1) to (G' 16-5), but at least one of Ar¹¹ and Ar¹² represents a group represented by the formula (G'1).

In the formula (1), k is an integer of 1 to 20, preferably 2 or more from the viewpoint of charge transportability, preferably 10 or less, more preferably 5 or less from the viewpoint of solubility of the precursor in an organic solvent.

In the formula (1), from the viewpoint of availability of raw material compounds, easy synthesis of the precursor, etc., preferably all Ar¹¹s and all Ar¹²s represent the same group, or all Ar¹¹s represent the same group and all Ar¹²s represent the same group.

Furthermore, preferable conditions for R¹¹ to R¹⁹⁹ and Ar¹³ in the formula (1) and the groups contained therein are the same as those described above.

In the present invention, the alkyl group, alkenyl group and alkynyl group have preferably 10 or less carbon atoms, more preferably 6 or less carbon atoms, even more preferably 4 or less carbon atoms.

The aryl group and the heteroaryl group have preferably 14 or less carbon atoms, more preferably 10 or less carbon atoms, even more preferably 6 or less carbon atoms.

In the present invention, taking into consideration of the balance between the availability of raw materials for the aniline derivatives, the solubility of the compounds, the charge transportability of the obtained charge-transporting thin film, and the like, an example of the preferable aniline derivative is represented by the formula (1').

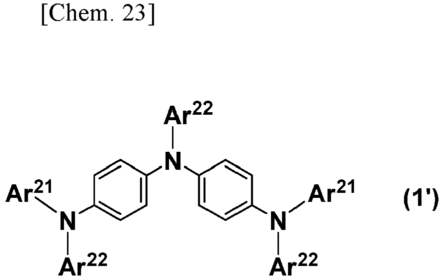

In the formula (1'), Ar²¹ and Ar²² are each independently a hydrogen atom, a group represented by the formula (2) or the group represented by the formula (3), but at least one of two Ar²¹s and three Ar²²s is a group represented by the formula (3).

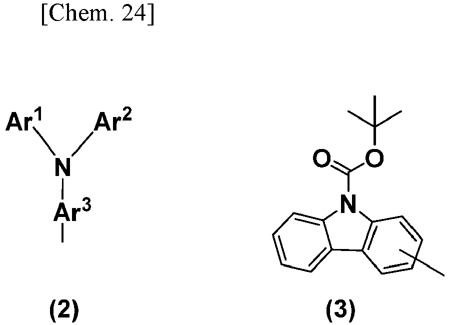

In the formula (2), Ar¹ and Ar² each independently represent a C6-20 aryl group, and Ar³ represents a C6-20 arylene group. Any two of Ar¹ to Ar³ may be bonded to each other to form a ring together with a nitrogen atom.

Specific examples of the C6-20 aryl group include a phenyl group, a 1-naphthyl group, a 2-naphthyl group, a 1-anthryl group, a 2-anthryl group, a 9-anthryl group, a 1-phenanthryl group, a 2-phenantril group, a 3-phenantril group, a 4-phenantril group and a 9-phenantril group.

Specific examples of the C6-20 arylene group include a benzene-1,2-diyl(o-phenylene) group, a benzene-1,3-diyl(m-phenylene) group, a benzene-1,4-diyl((p-phenylene) group, a naphthalene-1,2-diyl group, a naphthalene-1,3-diyl group, a naphthalene-1,4-diyl group, a naphthalene-1,5-diyl group, a naphthalene-1,6-diyl group, a naphthalene-1,7-diyl group and a naphthalene-1,8-diyl group.

The ring formed by the bonding of any two of Ar¹ to Ar³ together with a nitrogen atom includes a carbazole ring.

Among them, Ar¹ and Ar² are preferably a phenyl group, a 1-naphthyl group or a 2-naphthyl group, more preferably a phenyl group.

In addition, Ar³ is preferably a benzene-1,2-diyl group, a benzene-1,3-diyl group or a benzene-1,4-diyl group, more preferably a benzene-1,4-diyl group.

Accordingly, the group represented by the formula (2) is preferably a group represented by the formula (2A), more preferably a group represented by the formula (2A-1).

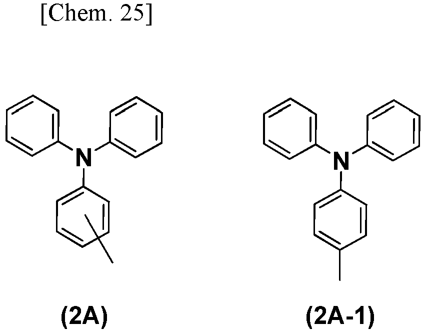

The group represented by the formula (3) is preferably a group represented by the following formula (3A).

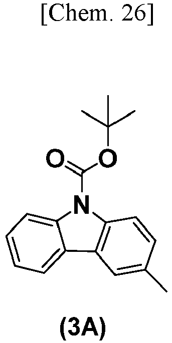

The aniline derivatives represented by the formula (1') are preferably symmetrical from the viewpoint of easy synthesis. Specific examples of them includes those in which all Ar²¹ and all Ar²² are the same group (for example, the formula (1'-1)), or those in which all Ar²¹ are the same group and all Ar²² are the same group (for example, the formulas (1'-2) and (1'-3)). 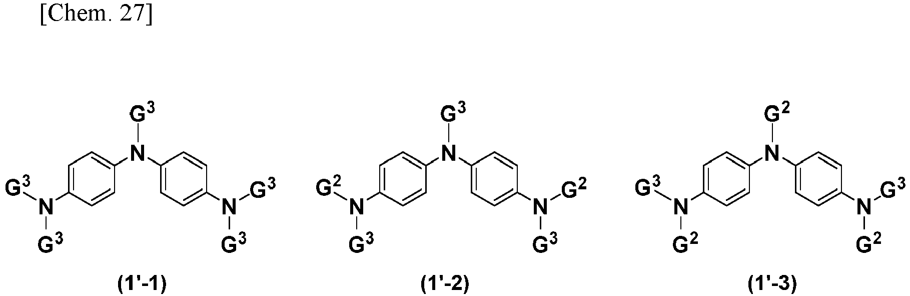 (In the formula, G² indicates a group represented by the formula (2A-1), and G³ indicates a group represented by the formula (3A).)

The aniline derivative represented by the formula (1) used in the present invention can be produced by reacting an amine compound represented by the formula (5) with an aryl compound represented by the formula (6) in the presence of a catalyst to prepare an amine compound represented by the formula (7), and then reacting the amine compound represented by the formula (7) with an aryl compound represented by the formula (8) in the presence of a catalyst. 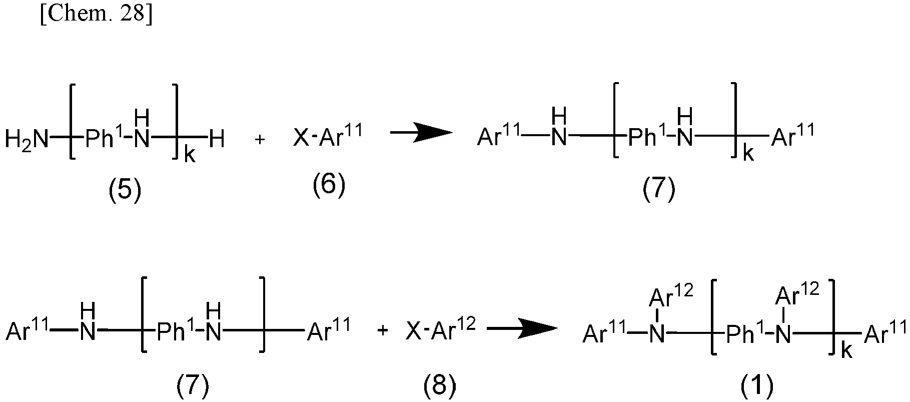 (In the formula, X represents a halogen atom or a pseudohalogen group, and Ar¹¹, Ar¹², Ph¹ and k have the same meanings as described above.)

The halogen atom includes the same as those described above.
The pseudohalogen group includes (fluoro)alkylsulfonyloxy groups such as a methanesulfonyloxy group, a trifluoromethanesulfonyloxy group and a nonaflatebutanesulfonyloxy group; and aromatic sulfonyloxy groups such as a benzenesulfonyloxy group and a toluenesulfonyloxy group.

The charging ratio of the amine compound represented by the formula (5) to the aryl compound represented by the formula (6) may be 2 equivalents or more of the aryl compound to the amount of the amine compound, but is suitably about 2 to 2.4 equivalents. In this reaction, the amino group (-NH2) represented by the formula (5) has so low steric hindrance and the like, that introduction of the Ar¹¹ groups to both ends predominantly progresses.

In addition, the charging ratio of the amine compound represented by the formula (7) to the aryl compound represented by the formula (8) may be 2 equivalents or more of the aryl compound to the amount of the amine compound, but is suitably about 2 to 2.4 equivalents.

When producing the aniline derivative represented by the formula (1) in which Ar¹¹ and Ar¹² are the same group, it may be produced in two steps of preparing the amine compound represented by the formula (7) and then preparing the aniline derivative represented by the formula (1), as described above, or may be produced in one step. In that case, the charging of the corresponding aryl compound (compound represented by the formulas (6) and (8)) is about 4 to 4.8 equivalents with respect to the amine compound represented by the formula (5).

Examples of the catalyst used in the reaction include copper catalysts such as copper chloride, copper bromide and copper iodide; and palladium catalysts such as Pd(PPh₃)₄ (tetrakis(triphenylphosphine)palladium), Pd(PPh₃)₂Cl₂ (bis(triphenylphosphine)dichloropalladium), Pd(dba)₂ (bis(dibenzylideneacetone)palladium), Pd₂(dba)₃ (tris(dibenzylideneacetone)dipalladium), Pd(P-t-Bu₃)₂ (bis(tri(t-butylphosphine))palladium) and Pd(OAc)₂ (palladium acetate). One of these catalysts may be used alone, or two or more thereof may be used in combination. In addition, these catalysts may be used together with a publicly known suitable ligand.

Such a ligand includes tertiary phosphines such as triphenylphosphine, tri-o-tolylphosphine, diphenylmethylphosphine, phenyldimethylphosphine, trimethylphosphine, triethylphosphine, tributylphosphine, tri-t-butylphosphine, di-t-butyl(phenyl)phosphine, di-t-butyl(4-dimethylaminophenyl)phosphine, 1,2-bis(diphenylphosphino)ethane, 1,3-bis(diphenylphosphino)propane, 1,4-bis(diphenylphosphino)butane and 1,1'-bis(diphenylphosphino)ferrocene, and tertiary phosphites such as trimethyl phosphite, triethyl phosphite and triphenyl phosphite.

The amount of the catalyst used may be about 0.2 mol per 1 mol of the aryl compound, but about 0.15 mol is preferable.

When a ligand is used, the amount of the ligand used may be 0.1 to 5 equivalents with respect to the metal complex used, but 1 to 2 equivalents are preferable.

When all raw material compounds are solid, or from the viewpoint of efficiently yielding the desired aniline derivative, each of the reactions is carried out in a solvent. When a solvent is used, the type of the solvent is not particularly limited as long as it does not adversely affect the reaction. Specific examples of the solvent include aliphatic hydrocarbons (such as pentane, n-hexane, n-octane, n-decane and decalin), halogenated aliphatic hydrocarbons (such as chloroform, dichloromethane, dichloroethane and carbon tetrachloride), aromatic hydrocarbons (such as benzene, nitrobenzene, toluene, o-xylene, m-xylene, p-xylene and mesitylene), halogenated aromatic hydrocarbons (such as chlorobenzene, bromobenzene, o-dichlorobenzene, m-dichlorobenzene and p-dichlorobenzene), ethers (such as diethyl ether, diisopropyl ether, t-butyl methyl ether, tetrahydrofuran, dioxane, 1,2-dimethoxyethane and 1,2-diethoxyethane), ketones (such as acetone, methyl ethyl ketone, methyl isobutyl ketone, di-n-butyl ketone and cyclohexanone), amides (such as N,N-dimethylformamide and N,N-dimethylacetamide), lactams and lactones (N-methylpyrrolidone and γ-butyrolactone), ureas (such as N,N-dimethylimidazolidinone and tetramethylurea), sulfoxides (such as dimethyl sulfoxide and sulfolane), and nitriles (such as acetonitrile, propionitrile and butyronitrile). One of these solvents may be used alone, or two or more thereof may be used in combination.

The reaction temperature may be appropriately set in the range from the melting point to the boiling point of the solvent to be used, but is particularly preferably about 0 to 200°C, more preferably 20 to 150°C.

After completion of the reaction, post-treatment may be carried out in accordance with the usual method to yield the desired aniline derivative.

In addition, the aniline derivative represented by the formula (1') used in the present invention can be produced by reacting an amine compound represented by the following formula (9) with an aryl compound represented by the formula (10) in the presence of a catalyst to prepare an amine compound represented by the formula (11), and then reacting an amine compound represented by the formula (12) with the aryl compound represented by the formula (8) in the presence of a catalyst. In this case, various conditions for the reaction (charging ratio, catalyst, solvent, etc.) can be referred to the contents described above for the formula (1). 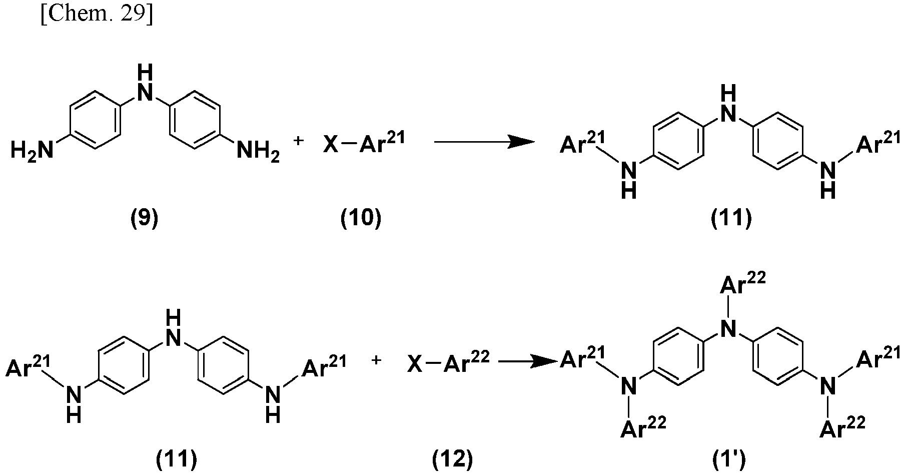 (In the formula, X, Ar²¹ and Ar²² have the same meanings as described above.)

A compound represented by the following formula (G1"), which is a raw material used in the present invention, can be prepared by a publicly known method including reacting a corresponding carbazole with a Boc reagent such as di-t-butyldicarbonate in the presence of a base such as pyridine or triethylamine. 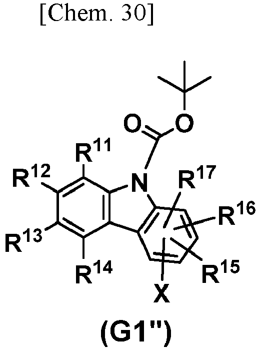 (In the formula, X and R¹¹ to R¹⁷ have the same meanings as described above.)

In addition, the charge-transporting substance precursor having a 9-t-butoxycarbonyl carbazole structure in the molecule used in the present invention, for example, the aniline derivative represented by the formula (1) or the formula (1') can also be produced by removing from a compound having another group except the Boc group at the 9-position of the carbazole moiety the other group to prepare a compound in which a proton is at the 9-position of the carbazole moiety, and introducing a Boc group at the 9-position of the carbazole moiety in the prepared compound.

The other group is not particularly limited as long as it is a group which can be appropriately removed, and typical examples include, but are not limited to, protecting groups such as a t-butyldimethylsilyl group and a benzyl group which can be desorbed under relatively mild conditions. Desorption of the other group can be carried out by a treating method under an acidic or basic condition, a treating method under an oxidizing or reducing condition, etc. For example, a publicly known appropriate method may be used in consideration of the properties of the other group, with reference to GREEN'S PROTECTIVE GROUPS in Organic Synthesis, 4th Edition.

Introduction of the Boc group can be carried out by a publicly known method including reacting a compound in which a proton is at the 9-position of the carbazole moiety with a Boc reagent such as di-t-butyldicarbonate in the presence of a base such as pyridine or triethylamine.

Specific examples of the reaction are given below, but the reaction is not limited thereto.

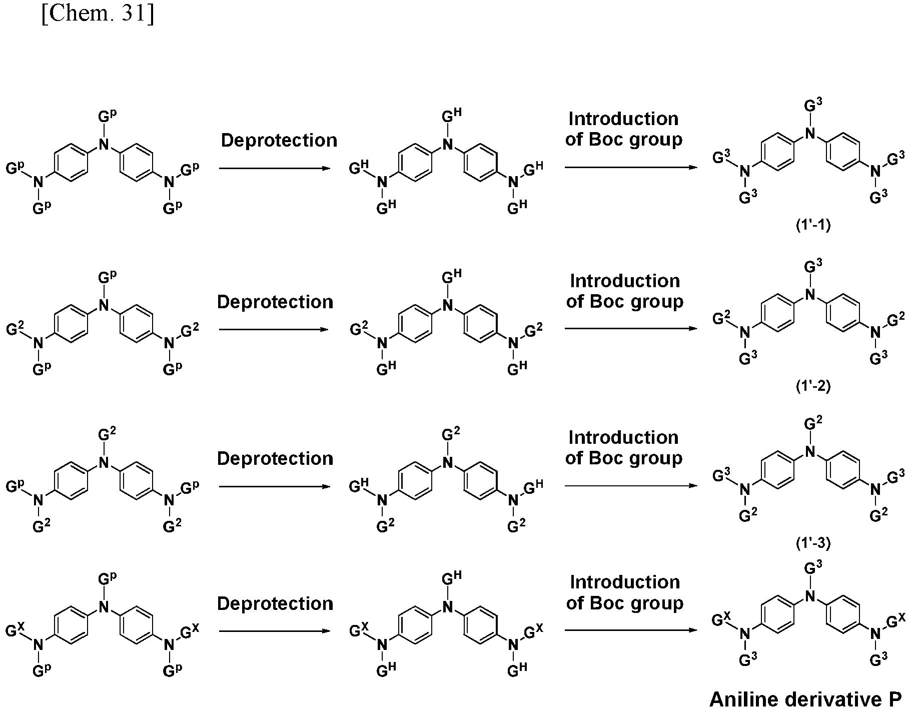

(In the formula, G^{p} represents a group represented by the following formula (3A-P), G^{H} represents a group represented by the following formula (3A-H), and G^{X} represents a 4-diphenylaminophenyl group, and G² and G³ have the same meanings as described above.) 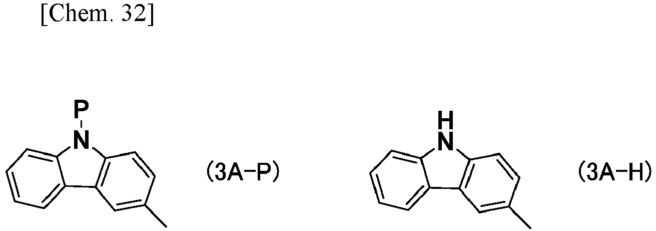 (P represents a protecting group other than the Boc group.)

The aniline derivatives represented by the formula (1) are preferably symmetrical from the viewpoint of easy synthesis. Specific examples of them include, but are not limited to, a compound represented by the following formula (1A) in which all of R¹ to R⁵ are groups represented by the formula (3A), a compound represented by the following formula (1B) in which R¹, R³ and R⁵ are hydrogen atoms, and R² and R⁴ are groups represented by the formula (3A), a compound represented by the following formula (1C) in which R¹, R³ and R⁵ are groups represented by the formula (2A-1), and R² and R⁴ are groups represented by the formula (3A), and a compound represented by the following formula (1D) in which R¹, R³ and R⁵ are groups represented by the formula (3A), and R² and R⁴ are groups represented by the formula (2A-1).

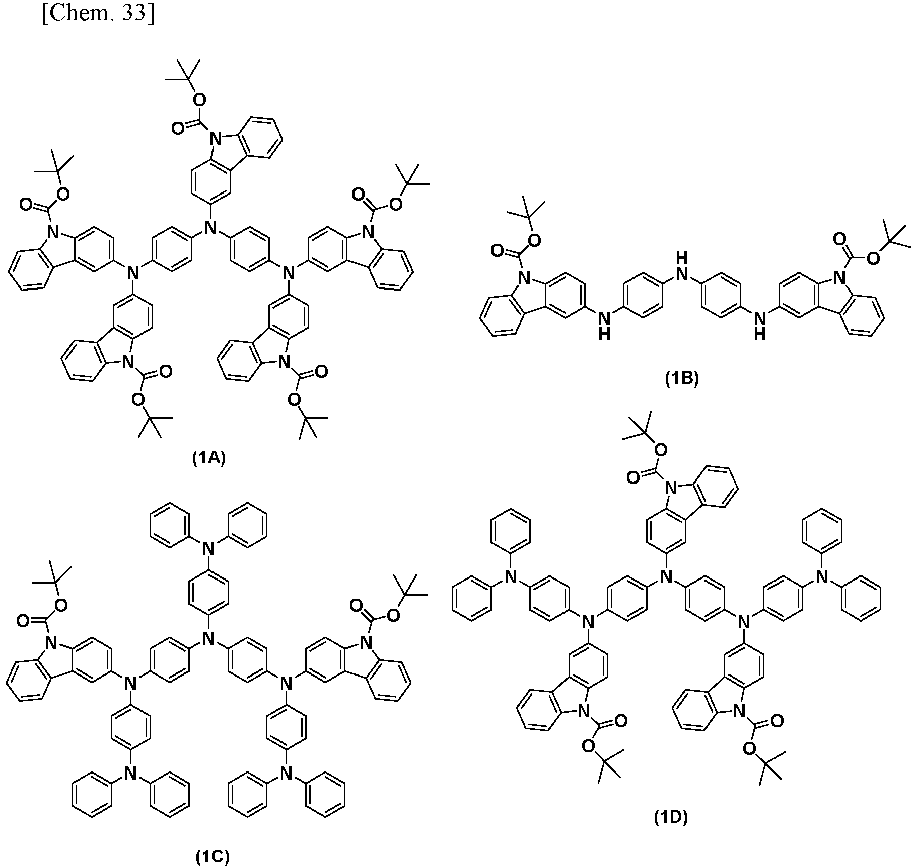

The aniline derivative represented by the formula (1') used in the present invention can be produced by subjecting an amine compound represented by the following formula (1") to a coupling reaction with a carbazole compound represented by the following formula (3') in the presence of a catalyst and a base.

The compound represented by the formula (3') can be prepared by a publicly known method including reacting a corresponding carbazole with a Boc reagent such as di-t-butyldicarbonate in the presence of a base such as pyridine or triethylamine. 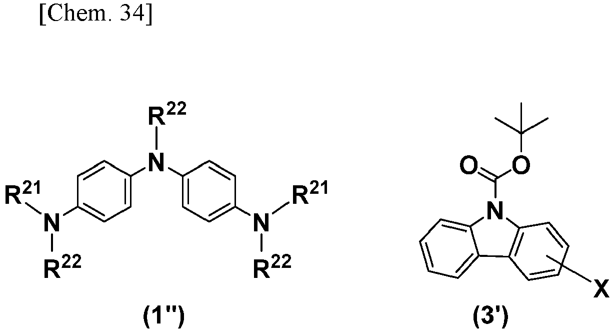 (In the formula, X and R²¹ to R²² have the same meanings as described above.)

The composition for forming a charge-transporting thin film of the present invention contains the charge-transporting substance precursor having a 9-t-butoxycarbonyl carbazole structure in the molecule and an organic solvent, and optionally contains a dopant substance for the purpose of improving the charge transporting ability, depending on the application of the resulting thin film, etc.

The dopant substance is not particularly limited as long as it is soluble in at least one kind of solvents used in the composition, but either an inorganic dopant substance or an organic dopant substance may be used.

Furthermore, the dopant substance may be a substance whose function as a dopant substance is finally expressed or improved through removal of a part in the molecule, for example, by external stimulus such as heating during baking in the process of preparing a charge-transporting thin film, which is a solid film, from the composition. Examples of the dopant substance may be an aryl sulfonate compound protected by a group by which the sulfonic acid group is easily desorbed.

The inorganic dopant substance is preferably a heteropolyacid. Specific examples of the heteropolyacid include phosphomolybdic acid, silicate molybdic acid, phosphotungstic acid, phosphotungstic molybdic acid and silicate tungstic acid.

The heteropolyacid has a structure, in which the heteroatom is located in the center of the molecule, typically represented by the chemical structure of Keggin type represented by the formula (D1) or Dawson type represented by the formula (D2), and is a polyacid formed by condensing an isopolyacid which is an oxygen acid of, for example, vanadium (V), molybdenum (Mo) or tungsten (W) with an oxygen acid of a heteroelement. Such oxygen acids of a heteroelement mainly include oxygen acids of silicon (Si), phosphorus (P) and arsenic (As).

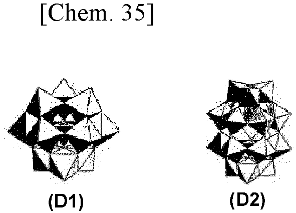

Specific examples of the heteropolyacid include phosphomolybdic acid, silicate molybdic acid, phosphotungstic acid, silicate tungstic acid and phosphotungstic acid. These may be used alone, or two or more of them may be used in combination. The heteropolyacid used in the present invention is commercially available or can be synthesized by a publicly known method.

In particular, when using one kind of heteropolyacid, the one kind of heteropolyacid is preferably phosphotungstic acid or phosphomolybdic acid, optimally phosphotungstic acid. When two or more kinds of heteropolyacids are used, one of the two or more kinds of heteropolyacids is preferably phosphotungstic acid or phosphomolybdic acid, more preferably phosphotungstic acid.

Heteropolyacids in a quantitative analysis such as an elemental analysis can be used in the present invention even if the number of elements is higher or lower than that of the structure represented by the general formula, as long as they are obtained as a commercial product or properly synthesized in accordance with a publicly known synthesis method.

In other words, for example, in general, where phosphotungstic acid is represented by the chemical formula H₃(PW₁₂O₄₀)·nH₂O, and phosphomolybdic acid is represented by the chemical formula H₃(PMO₁₂O₄₀)·nH₂O, heteropolyacids in a quantitative analysis can be used in the present invention, even if the number of P (phosphorus), O (oxygen), or W (tungsten) or Mo (molybdenum) in these formulas is higher or lower, as long as they are obtained as a commercial product or properly synthesized in accordance with a publicly known synthesis method. In this case, the weight of the heteropolyacid defined in the present invention does not mean the weight of pure phosphotungstic acid (content of phosphotungstic acid) in a synthetic or commercial product but means the total weight containing hydrated water, other impurities, and the like, in commercially available forms and in forms that can be isolated by a publicly known synthetic method.

The heteropolyacid contained in the composition for forming a charge-transporting thin film of the present invention may be about 0.01 to 50 with respect to 1 charge-transporting substance in weight ratio, but is preferably about 0.1 to 10, more preferably about 1.0 to 5.0.

The organic dopant substances include aryl sulfonic acids, aryl sulfonates, ionic compounds composed of a predetermined anion and its counter cation, tetracyanoquinodimethane derivatives and benzoquinone derivatives.

The tetracyanoquinodimethane derivatives include 7,7,8,8-tetracyanoquinodimethane (TCNQ), 2-fluoro-7,7,8,8-tetracyanoquinodimethane, 2,5-difluoro-7,7,8,8-tetracyanoquinodimethane, tetrafluoro-7,7,8,8-tetracyanoquinodimethane (F4TCNQ), tetrachloro-7,7,8,8-tetracyanoquinodimethane, 2-fluoro-7,7,8,8-tetracyanoquinodimethane, 2-chloro-7,7,8,8-tetracyanoquinodimethane, 2,5-difluoro-7,7,8,8-tetracyanoquinodimethane and 2,5-dichloro-7,7,8,8-tetracyanoquinodimethane.

The benzoquinone derivatives include tetrachloro-1,4-benzoquinone (chloranil) and 2,3-dichloro-5,6-dicyano-1,4-benzoquinone (DDQ).

In particular, as the aryl sulfonic acid, a compound represented by the following formula (4) or (5) can be suitably used.

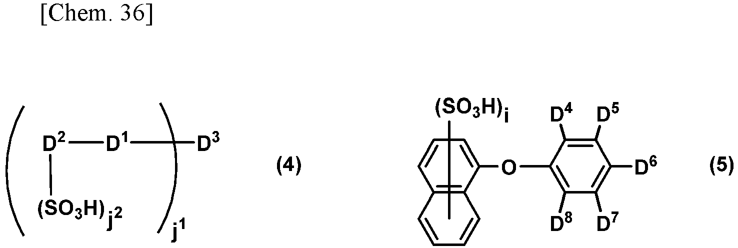

In the formula (4), D¹ represents -O- or -S-, but -O- is preferable. D² represents a naphthalene ring or an anthracene ring, but a naphthalene ring is preferable. D³ represents a bivalent to tetravalent perfluorobiphenyl group, and j¹ represents the number of bonds between D¹ and D³, and is an integer satisfying 2 ≤ j¹ ≤ 4, but it is preferable that D³ be a bivalent perfluorobiphenyl group, and j¹ be 2. j² represents the number of sulfonic acid groups bonded to D², and is an integer satisfying 1 ≤ j² ≤ 4, but 2 is suitable.

In the formula (5), D⁴ to D⁸ each independently represent a hydrogen atom, a halogen atom, a cyano group, a C1-20 alkyl group, a C1-20 halogenated alkyl group or a C2-20 halogenated alkenyl group, provided that at least three of D⁴ to D⁸ are halogen atoms. i represents the number of sulfonic acid groups bonded to the naphthalene ring, and is an integer satisfying 1 ≤ i ≤ 4, but 2 to 4 is preferable, and 2 is more preferable.

The C1-20 alkyl group may be linear, branched or cyclic. Examples of the C1-20 alkyl group include C1-20 linear or branched alkyl groups such as a methyl group, an ethyl group, an n-propyl group, an isopropyl group, an n-butyl group, an isobutyl group, an s-butyl group, a t-butyl group, an n-pentyl group, an n-hexyl group, an n-heptyl group, an n-octyl group, an n-nonyl group and an n-decyl group; and C3-20 cyclic alkyl groups such as a cyclopropyl group, a cyclobutyl group, a cyclopentyl group, a cyclohexyl group, a cycloheptyl group, a cyclooctyl group, a cyclononyl group, a cyclodecyl group, a bicyclobutyl group, a bicyclopentyl group, a bicyclohexyl group, a bicycloheptyl group, a bicyclooctyl group, a bicyclononyl group and a bicyclodecyl group.

The C1-20 halogenated alkyl group includes a trifluoromethyl group, a 2,2,2-trifluoroethyl group, a perfluoroethyl group, a 3,3,3-trifluoropropyl group, a 2,2,3,3,3-pentafluoropropyl group, a perfluoropropyl group, a 4,4,4-trifluorobutyl group, a 3,3,4,4,4-pentafluorobutyl group, a 2,2,3,3,4,4,4-heptafluorobutyl group and a perfluorobutyl group. The C2-20 halogenated alkenyl group includes a perfluorovinyl group, a 1-perfluoropropenyl group, a perfluoroallyl group and a perfluorobutenyl group.

Examples of the halogen atom include the same as those described above, but a fluorine atom is preferable.

Among them, it is preferable that D⁴ to D⁸ be a hydrogen atom, a halogen atom, a cyano group, a C1-10 alkyl group, a C1-10 halogenated alkyl group or a C2-10 halogenated alkenyl group, and at least three of D⁴ to D⁸ be fluorine atoms, it is more preferable that D⁴ to D⁸ be a hydrogen atom, a fluorine atom, a cyano group, a C1-5 alkyl group, a C1-5 fluorinated alkyl group or a C2-5 fluorinated alkenyl group, and at least three of D⁴ to D⁸ be fluorine atoms, and it is even more preferable that D⁴ to D⁸ be a hydrogen atom, a fluorine atom, a cyano group, a C1-5 perfluoroalkyl group or a C1-5 perfluoroalkenyl group, and D⁴, D⁵ and D⁸ be fluorine atoms.

Note that the perfluoroalkyl group is a group in which all the hydrogen atoms of the alkyl group are substituted with fluorine atoms, and the perfluoroalkenyl group is a group in which all the hydrogen atoms of the alkenyl group are substituted with fluorine atoms.

Specific examples of suitable aryl sulfonic acids include, but are not limited to, those represented below.

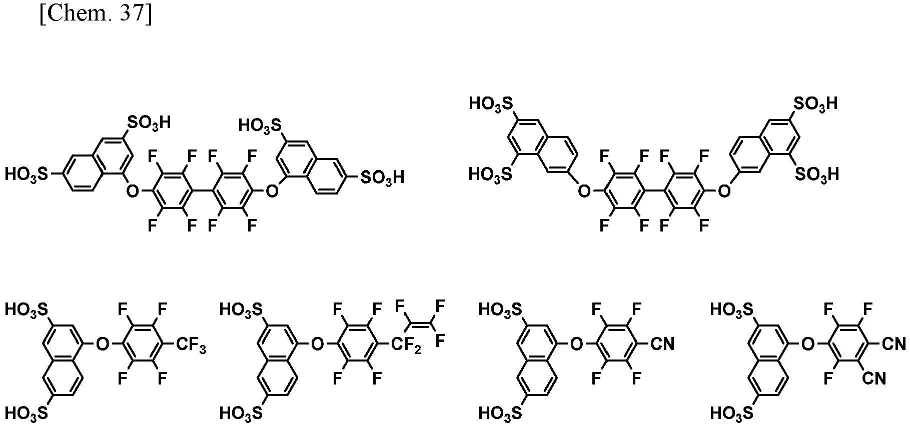

Especially from the viewpoint of storage stability of the composition, aryl sulfonate compounds are suitable. For example, an aryl sulfonate compound represented by the following formula (6) or (6') can be preferably used.

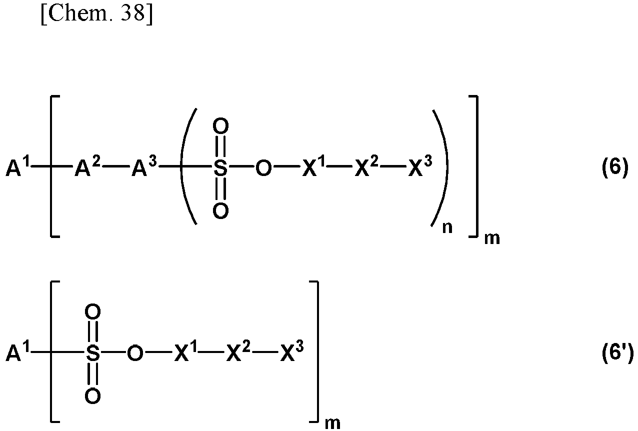

In the formulas (6) and (6'), A¹ is a C6-20 m-valent hydrocarbon group containing one or more aromatic rings, or an m-valent group derived from a compound represented by the following formula (7) or (8), which may have a substituent. 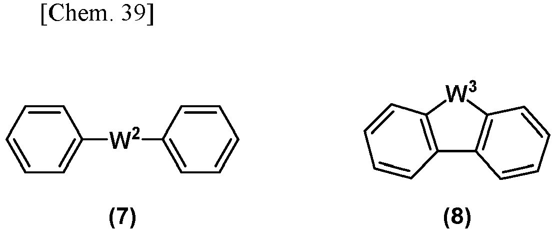 (In the formula, W² and W³ are each independently -O-, -S-, -S(O)- or -S(O₂)-, or -N-, -Si-, -P- or -P(O)- which may have a substituent.

The C6-20 m-valent hydrocarbon group containing one or more aromatic rings is a group obtained by removing m hydrogen atoms from a C6-20 hydrocarbon containing one or more aromatic rings. The hydrocarbon containing one or more aromatic rings includes benzene, toluene, xylene, biphenyl, naphthalene, anthracene and pyrene. Among them, as the hydrocarbon group, a group derived from benzene, biphenyl or the like is preferable.

Some or all of the hydrogen atoms of the hydrocarbon group may be further substituted with a substituent. The substituent includes a fluorine atom, a chlorine atom, a bromine atom, an iodine atom, a nitro group, a cyano group, a hydroxy group, an amino group, a silanol group, a thiol group, a carboxy group, a sulphonate group, a phosphoric acid group, a phosphate group, an ester group, a thioester group, an amide group, a univalent hydrocarbon group, an organooxy group, an organoamino group, an organosilyl group, an organothio group, an acyl group and a sulfo group.

The univalent hydrocarbon group includes C1-10 alkyl groups such as a methyl group, an ethyl group, an n-propyl group, an isopropyl group, an n-butyl group, an isobutyl group, an s-butyl group, a t-butyl group, an n-pentyl group, a cyclopentyl group, an n-hexyl group, a cyclohexyl group, an n-heptyl group, an n-octyl group, an n-nonyl group and an n-decyl group; C2-10 alkenyl groups such as a vinyl group, a 1-propenyl group, a 2-propenyl group, an isopropenyl group, a 1-methyl-2-propenyl group, a 1-butenyl group, a 2-butenyl group, a 3-butenyl group and a hexenyl group; C6-20 aryl groups such as a phenyl group, a xylyl group, a tolyl group, a 1-naphthyl group and a 2-naphthyl group; and C7-20 aralkyl groups such as a benzyl group and a phenylethyl group.

The organooxy group includes an alkoxy group, an alkenyloxy group and an aryloxy group. The alkyl group, alkenyl group and aryl group contained in these groups include the same as those described above.

The organoamino groups include C1-12 alkylamino groups such as a methylamino group, an ethylamino group, a propylamino group, a butylamino group, a pentylamino group, a hexylamino group, a cyclohexylamino group, a heptylamino group, an octylamino group, a nonylamino group, a decylamino group and a dodecylamino group; dialkylamino groups in which each alkyl group is a C1-12 alkyl group such as a dimethylamino group, a diethylamino group, a dipropylamino group, a dibutylamino group, a dipentylamino group, a dihexylamino group, a dicyclohexylamino group, a diheptylamino group, a dioctylamino group, a dinonylamino group and a didecylamino group; and a morpholino group.

The organosilyl group includes trialkylsilyl groups in which each alkyl group is a C1-10 alkyl group, such as a trimethylsilyl group, a triethylsilyl group, a tripropylsilyl group, a tributylsilyl group, a tripentylsilyl group, a trihexylsilyl group, a pentyldimethylsilyl group, a hexyldimethylsilyl group, an octyldimethylsilyl group and a decyldimethylsilyl group.

The organothio group includes C1-12 alkylthio groups such as a methylthio group, an ethylthio group, a propylthio group, a butylthio group, a pentylthio group, a hexilthio group, a heptilthio group, an octylthio group, a nonylthio group, a decylthio group and a dodecylthio group.

The acyl group includes C1-10 acyl groups such as a formyl group, an acetyl group, a propionyl group, a butyryl group, an isobutyryl group, a valeryl group, an isovaleryl group and a benzoyl group.

The univalent hydrocarbon group, organooxy group, organoamino group, organoamino group, organosilyl group, organothio group and acyl group preferably have 1 to 8 carbon atoms.

Among these substituents, a fluorine atom, a sulfonic acid group, an alkyl group, an organooxy group and an organosilyl group are more preferable.

In the formula (6), A² is -O-, -S- or -NH-. Among them, -O- is preferable because of easy synthesis.

In the formula (6), A³ is a C6-20 (n+1)-valent aromatic group. The aromatic group is a group obtained by removing hydrogen atoms on the aromatic ring from a C6-20 aromatic compound (n+1). In this invention, the aromatic compound means an aromatic hydrocarbon and an aromatic heterocyclic compound. The aromatic compound includes benzene, toluene, xylene, biphenyl, naphthalene, anthracene and pyrene. Among them, as the aromatic group represented by A³, a group derived from naphthalene or anthracene is preferable.

In the formulas (6) and (6'), X¹ is a C2-5 alkylene group. In addition, the alkylene group may have -O-, -S- or a carbonyl group interposed between the carbon atoms, in which some or all of the hydrogen atoms may be further substituted with a C1-20 alkyl group. X¹ is preferably an ethylene group, a trimethylene group, a methyleneoxymethylene group, a methylenethiomethylene group, or the like. Some or all of the hydrogen atoms of these groups may be further substituted with a C1-20 alkyl group. The alkyl group includes a methyl group, an ethyl group, an n-propyl group, an isopropyl group, an n-butyl group, an isobutyl group, an s-butyl group, a t-butyl group, an n-pentyl group, a cyclopentyl group, an n-hexyl group, a cyclohexyl group, an n-heptyl group, an n-octyl group, an n-nonyl group, an n-decyl group, an n-undecyl group, an n-dodecyl group and a bicyclohexyl group.

In the formulas (6) and (6'), X² is a single bond, -O-, -S- or -NR^{a}-. R^{a} is a hydrogen atom or a C1-10 univalent hydrocarbon group. As the univalent hydrocarbon group, an alkyl group such as a methyl group, an ethyl group or an n-propyl group is preferable. As X², a single bond, -O- or -S- is preferable, and a single bond or -O- is more preferable.

In the formulas (6) and (6'), X³ is a C1-20 univalent hydrocarbon group which may be substituted. The univalent hydrocarbon group includes C1-20 alkyl groups such as a methyl group, an ethyl group, an n-propyl group, an isopropyl group, an n-butyl group, an isobutyl group, an s-butyl group, a t-butyl group, an n-pentyl group, a cyclopentyl group, an n-hexyl group, a cyclohexyl group, an n-heptyl group, an n-octyl group, an n-nonyl group, an n-decyl group, an n-undecyl group, an n-dodecyl group and a bicyclohexyl group; C2-20 alkenyl groups such as a vinyl group, a 1-propenyl group, a 2-propenyl group, an isopropenyl group, a 1-methyl-2-propenyl group, a 1-butenyl group, a 2-butenyl group, a 3-butenyl group and a hexenyl group; C6-20 aryl groups such as a phenyl group, a xylyl group, a tolyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthril group, a 2-biphenylyl group, a 3-biphenylyl group and a 4-biphenylyl group; and C7-20 aralkyl groups such as a benzyl group, a phenylethyl group and a phenylcyclohexyl group. In addition, some or all of the hydrogen atoms of the univalent hydrocarbon group may be further substituted with a substituent. The substituent includes the same as those described in A¹. X³ is preferably a C1-20 alkyl group or a C6-20 aryl group.

In the formulas (6) and (6'), m is an integer satisfying 1 ≤ m ≤ 4, but 2 is preferable. n is an integer satisfying 1 ≤ n ≤ 4, but 2 is preferable.

The aryl sulfonate compound represented by the formula (6) or (6') has so high solubility in a wide range of solvents including low-polarity solvents that the physical properties of a solution can be adjusted using a wide variety of solvents, achieving high coating properties. Accordingly, it is preferable that application is performed in the state of sulfonate to generate sulfonic acid during drying or baking of the coating film. The temperature at which sulfonic acid is generated from the sulfonate may be 40 to 260°C because they are stable at room temperature and the temperature is preferably a temperature not higher than the baking temperature. Furthermore, taking into consideration of the high stability in the composition and the ease of desorption during firing, 80 to 230°C is preferable, and 120 to 180°C is more preferable.

As the aryl sulfonate compound represented by the formula (6), compounds represented by any of the following formulas (6-1) to (6-3) are preferable. 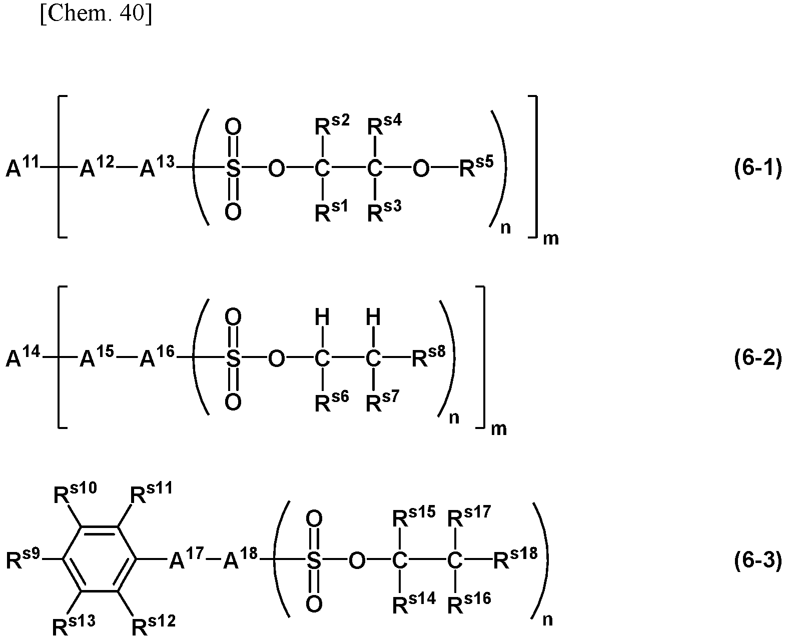 (In the formula, m and n are the same as those described above.)

In the formula (6-1), A¹¹ is an m-valent group derived from perfluorobiphenyl. A¹² is -O- or -S-, but -O- is preferable. A¹³ is a (n+1)-valent group derived from naphthalene or anthracene, but is preferably a group derived from naphthalene.

In the formula (6-1), R^{s1} to R^{s4} are each independently a hydrogen atom or a linear or branched C1-6 alkyl group, and R^{s5} is a C2-20 univalent hydrocarbon group which may be substituted.

The linear or branched alkyl group includes, but is not particularly limited to, a methyl group, an ethyl group, an n-propyl group, an isopropyl group, an n-butyl group, an isobutyl group, a t-butyl group and an n-hexyl group. Among them, C1-3 alkyl groups are preferable.

The C2-20 univalent hydrocarbon group includes alkyl groups such as an ethyl group, an n-propyl group, an isopropyl group, an n-butyl group, an isobutyl group and a t-butyl group, and aryl groups such as a phenyl group, a naphthyl group and a phenanthryl group.

Among R^{s1} to R^{s4}, it is preferable that R^{s1} or R^{s3} be a linear C1-3 alkyl group and the rest be hydrogen atoms, or R^{s1} be a linear C1-3 alkyl group and R^{s2} to R^{s4} be hydrogen atoms. As the linear C1-3 alkyl group, a methyl group is preferable. In addition, R^{s5} is preferably a linear C2-4 alkyl group or a phenyl group.

In the formula (6-2), A¹⁴ is a C6-20 m-valent hydrocarbon group containing one or more aromatic rings which may be substituted. The hydrocarbon group is a group obtained by removing m hydrogen atoms from a C6-20 hydrocarbon containing one or more aromatic rings. The hydrocarbon includes benzene, toluene, xylene, ethylbenzene, biphenyl, naphthalene, anthracene and phenanthrene. In addition, the hydrocarbon group may have some or all of the hydrogen atoms further substituted with a substituent, the substituent including the same as those described in A¹. Preferable A¹⁴ includes the same as those described as the suitable examples of A¹.

In the formula (6-2), A¹⁵ is -O- or -S-, but -O- is preferable.

In the formula (6-2), A¹⁶ is a C6-20 (n+1)-valent aromatic group. The aromatic group is a group obtained by removing (n+1) hydrogen atoms from the aromatic ring of a C6-20 aromatic compound. The aromatic compound includes benzene, toluene, xylene, biphenyl, naphthalene, anthracene and pyrene. Among them, A¹⁶ is preferably a group derived from naphthalene or anthracene, more preferably a group derived from naphthalene.

In the formula (6-2), R^{s6} and R^{s7} are each independently a hydrogen atom, or a linear or branched univalent aliphatic hydrocarbon group. R^{s8} is a linear or branched univalent aliphatic hydrocarbon group, provided that the total carbon number of R^{s6}, R^{s7} and R^{s8} is 6 or more. The upper limit of the total carbon number of R^{s6}, R^{s7} and R^{s8} is not particularly limited, but is preferably 20 or less, more preferably 10 or less.

The linear or branched univalent aliphatic hydrocarbon group includes, but is not particularly limited to, C1-20 alkyl groups such as a methyl group, an ethyl group, an n-propyl group, an isopropyl group, an n-butyl group, an isobutyl group, a t-butyl group, an n-hexyl group, an n-octyl group, a 2-ethylhexyl group and a decyl group; and C2-20 alkenyl groups such as a vinyl group, a 1-propenyl group, a 2-propenyl group, an isopropenyl group, a 1-methyl-2-propenyl group, a 1-butenyl group, a 2-butenyl group, a 3-butenyl group and a hexenyl group.

R^{s6} is preferably a hydrogen atom, and R^{s7} and R^{s8} are preferably C1-6 alkyl groups. In this case, R^{s7} and R^{s8} may be the same as or different from each other.

In the formula (6-2), m is an integer satisfying 1 ≤ m ≤ 4, but 2 is preferable. n is an integer satisfying 1 ≤ n ≤ 4, but 2 is preferable.

In the formula (6-3), R^{s9} to R^{s13} are each independently a hydrogen atom, a nitro group, a cyano group, a halogen atom, a C1-10 alkyl group, a C1-10 halogenated alkyl group or a C2-10 halogenated alkenyl group.

The C1-10 alkyl group may be linear, branched or cyclic, and specific examples thereof include a methyl group, an ethyl group, an n-propyl group, an isopropyl group, an n-butyl group, an isobutyl group, an s-butyl group, a t-butyl group, an n-pentyl group, a cyclopentyl group, an n-hexyl group, a cyclohexyl group, an n-heptyl group, an n-octyl group, an n-nonyl group and an n-decyl group.

The C1-10 halogenated alkyl group is not particularly limited as long as it is a group in which some or all of the hydrogen atoms of a C1-10 alkyl group are substituted with a halogen atom. The halogenated alkyl group may be linear, branched, or cyclic, and specific examples thereof include a trifluoromethyl group, a 2,2,2-trifluoroethyl group, a 1,1,2,2,2-pentafluoroethyl group, a 3,3,3-trifluoropropyl group, a 2,2,3,3,3-pentafluoropropyl group, a 1,1,2,2,3,3,3-heptafluoropropyl group, a 4,4,4-trifluorobutyl group, a 3,3,4,4,4-pentafluorobutyl group, a 2,2,3,3,4,4,4-heptafluorobutyl group and a 1,1,2,2,3,3,4,4,4-nonafluorobutyl group.

The C2-10 halogenated alkenyl group is not particularly limited as long as it is a group in which some or all of the hydrogen atoms of a C2-10 alkenyl group are substituted with a halogen atom. Specific examples thereof include a perfluorovinyl group, a perfluoro-1-propenyl group, a perfluoro-2-propenyl group, a perfluoro-1-butenyl group, a perfluoro-2-butenyl group and a perfluoro-3-butenyl group.

Among them, R^{s9} is preferably a nitro group, a cyano group, a C1-10 halogenated alkyl group, a C2-10 halogenated alkenyl group and the like, more preferably a nitro group, a cyano group, a C1-4 halogenated alkyl group, a C2-4 halogenated alkenyl group and the like, and even more preferably a nitro group, a cyano group, a trifluoromethyl group, a perfluoropropenyl group and the like. In addition, R^{s10} to R^{s13} are preferably a halogen atom, more preferably a fluorine atom.

In the formula (6-3), A¹⁷ is -O-, -S- or -NH-, but -O- is preferable.

In the formula (6-3), A¹⁸ is a C6-20 (n+1)-valent aromatic group. The aromatic group is a group obtained by removing (n+1) hydrogen atoms from the aromatic ring of a C6-20 aromatic compound. The aromatic compound includes benzene, toluene, xylene, biphenyl, naphthalene, anthracene and pyrene. Among them, A¹⁸ is preferably a group derived from naphthalene or anthracene, more preferably a group derived from naphthalene.

In the formula (6-3), R^{s14} to R^{s17} are each independently a hydrogen atom, or a linear or branched C1-20 univalent aliphatic hydrocarbon group.

The univalent aliphatic hydrocarbon group includes C1-20 alkyl groups such as a methyl group, an ethyl group, an n-propyl group, an isopropyl group, an n-butyl group, an isobutyl group, an s-butyl group, a t-butyl group, an n-pentyl group, a cyclopentyl group, an n-hexyl group, a cyclohexyl group, an n-heptyl group, an n-octyl group, an n-nonyl group, an n-decyl group, an n-undecyl group and an n-dodecyl group; and C2-20 alkenyl groups such as a vinyl group, a 1-propenyl group, a 2-propenyl group, an isopropenyl group, a 1-methyl-2-propenyl group, a 1-butenyl group, a 2-butenyl group, a 3-butenyl group and a hexenyl group. Among them, a C1-20 alkyl group is preferable, a C1-10 alkyl group is more preferable, and a C1-8 alkyl group is even more preferable.

In the formula (6-3), R^{s18} is a linear or branched C1-20 univalent aliphatic hydrocarbon group, or OR^{s19}. R^{s19} is a C2-20 univalent hydrocarbon group which may be substituted.

The linear or branched C1-20 univalent aliphatic hydrocarbon group represented by R^{s18} includes the same as those described above. When R^{s18} is a univalent aliphatic hydrocarbon group, R^{s18} is preferably a C1-20 alkyl group, more preferably a C1-10 alkyl group, even more preferably a C1-8 alkyl group.

The C2-20 univalent hydrocarbon group represented by R^{s19} includes, in addition to those other than a methyl group among the univalent aliphatic hydrocarbon groups, aryl groups such as a phenyl group, a naphthyl group and a phenanthryl group. Among them, R^{s19} is preferably a linear C2-4 alkyl group or a phenyl group. In addition, the substituent that the univalent hydrocarbon group may have includes a fluoro group, a C1-4 alkoxy group, a nitro group and a cyano group.

In the formula (6-3), n is an integer satisfying 1 ≤ n ≤ 4, but 2 is preferable.

As the aryl sulfonate compound represented by the formula (6-3), compounds represented by the following formula (6-3-1) or (6-3-2) are particularly preferable.

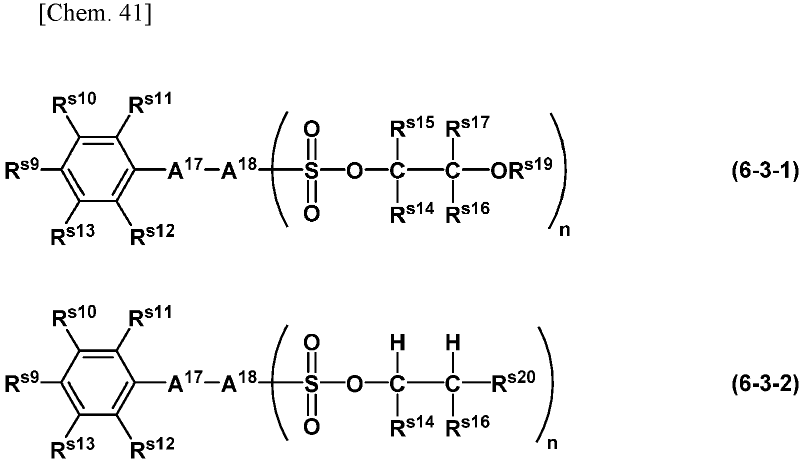

In the formula, A¹⁷, A¹⁸, R^{s9} to R^{s17}, R^{s19} and n are the same as those described above. R^{s20} is a linear or branched C1-20 univalent aliphatic hydrocarbon group, and specific examples thereof include the same as those described in R^{s18}.

In the aryl sulfonate compound represented by the formula (6-3-1), among R^{s14} to R^{s17}, it is preferable that R^{s14} or R^{s16} be a linear C1-3 alkyl group and the rest be hydrogen atoms, or R^{s14} be a linear C1-3 alkyl group and R^{s15} to R^{s17} be hydrogen atoms. As the linear C1-3 alkyl group, a methyl group is preferable. In addition, R^{s19} is preferably a linear C2-4 alkyl group or a phenyl group.

In the aryl sulfonate compound represented by the formula (6-3-2), the total carbon number of R^{s14}, R^{s16} and R^{s20} is preferably 6 or more. The upper limit of the total carbon number of R^{s14}, R^{s16} and R^{s20} is preferably 20 or less, more preferably 10 or less. In this case, R^{s14} is preferably a hydrogen atom, and R^{s16} and R^{s20} are preferably a C1-6 alkyl group. In addition, R^{s16} and R^{s20} may be the same as or different from each other.

The aryl sulfonate compounds represented by the formulas (6) and (6') may be used alone, or two or more of them may be used in combination.

Specific examples of suitable aryl sulfonate include, but are not limited to, the following one.

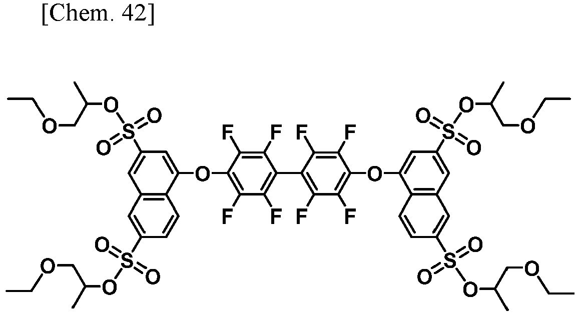

In the case of an organic dopant substance, its molecular weight is preferably 5,000 or less, more preferably 3,000 or less, even more preferably 2,000 or less, from the viewpoint of solubility in an organic solvent.

When the composition for forming a charge-transporting thin film of the present invention contains an organic dopant substance, the content is usually about 0.01 to 20 with respect to 1 charge-transporting substance in molar ratio.

Furthermore, when the obtained thin film is used as a hole injection layer for an organic EL device, for the purpose of improving the injection property into the hole injection layer, improving the lifetime characteristics of the device, etc., the composition for forming a charge-transporting thin film of the present invention may contain an organosilane compound. Its content is usually about 1 to 30 wt% per the weight of the charge-transporting substance.

As the organic solvent used in preparing the composition for forming a charge-transporting thin film of the present invention, a high dissolving solvent capable of successfully dissolving a charge-transporting substance precursor having a 9-t-butoxycarbonyl carbazole structure in the molecule may be used. In order to dissolve a charge-transporting substance precursor having in the molecule a carbazole structure free of a substituent on the nitrogen atom of a carbazole group, it is necessary to incorporate at least one high-polarity solvent. On the other hand, the charge-transporting substance precursor having a 9-t-butoxycarbonyl carbazole structure in the molecule used in the present invention can be dissolved in a solvent regardless of the polarity of the solvent, because of a t-butoxycarbonyl group on the nitrogen atom of a carbazole group. If necessary, a low-polarity solvent may be used in consideration of better process compatibility than that of a high-polarity solvent. In the present invention, a low-polarity solvent is defined as one having a relative permittivity of less than 7 at a frequency of 100 kHz, and a high-polarity solvent is defined as one having a relative permittivity of 7 or more at a frequency of 100 kHz.

Examples of the low-polarity solvent include chlorine-based solvents such as chloroform and chlorobenzene; aromatic hydrocarbon-based solvents such as alkylbenzenes such as toluene, xylene, tetralin, cyclohexylbenzene and decylbenzene; aliphatic alcohol-based solvents such as 1-octanol, 1-nonanol and 1-decanol; ether-based solvents such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether and triethylene glycol butyl methyl ether; ester-based solvents such as methyl benzoate, ethyl benzoate, butyl benzoate, isoamyl benzoate, bis(2-ethylhexyl)phthalate, dibutyl maleate, dibutyl oxalate, hexyl acetate, diethylene glycol monoethyl ether acetate and diethylene glycol monobutyl ether acetate.

In addition, examples of the high-polarity solvent include amide-based solvents such as N,N-dimethylformamide, N,N-dimethylacetamide, N,N-dimethylisobutyramide, N-methylpyrrolidone and 1,3-dimethyl-2-imidazolidinone; ketone-based solvents such as ethyl methyl ketone, isophorone and cyclohexanone; cyano-based solvent such as acetonitrile and 3-methoxypropionitrile; polyhydric alcohol-based solvents such as ethylene glycol, diethylene glycol, triethylene glycol, dipropylene glycol, 1,3-butanediol and 2,3-butanediol; monohydric alcohol-based solvents other than aliphatic alcohols such as diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, tetrahydrofurfuryl alcohol; and sulfoxide-based solvents such as dimethyl sulfoxide.

The viscosity of the composition for forming a charge-transporting thin film of the present invention is usually 1 to 50 mPa·s at 25°C, and the surface tension is usually 20 to 50 mN/m at 25°C.

The viscosity and surface tension of the composition for forming a charge-transporting thin film of the present invention can be adjusted by changing, for example, the type and ratio of organic solvent used or solid content concentration, taking into consideration of various factors such as the coating method used and the desired film thickness.

The composition for forming a charge-transporting thin film of the present invention can be produced by mixing the components described above.

In preparation of the composition, heating may be appropriately performed as long as the components are not decomposed or deteriorated.

In the present invention, for the purpose of preparing a thin film having higher flatness with good reproducibility, the composition for forming a charge-transporting thin film may be subjected to filtration in the middle of producing the composition or after mixing all the components using a filter on the submicro-order or the like.

By applying and baking the composition for forming a charge-transporting thin film described above on a substrate, a charge-transporting thin film can be formed on the substrate. In the present invention, during baking, the organic solvent is evaporated and a 9-t-butoxycarbonyl group is desorbed from the charge-transporting substance precursor, so that a thin film having excellent charge transportability can be obtained.

The method for applying the composition includes, but is not particularly limited to, a dip method, a spin coating method, a transfer printing method, a roll coating method, brush coating, an inkjet method and a spray method. Depending on the coating method, it is preferable to adjust the viscosity and surface tension of the composition.

In addition, when the composition of the present invention is used, the baking atmosphere is not particularly limited, and not only in the air atmosphere, but also in an inert gas such as nitrogen or in a vacuum, a thin film having a uniform film formation surface and high charge transportability can be obtained.

The baking temperature is appropriately set within the range of about 100 to 260°C, in consideration of the application of the obtained thin film, the degree of charge transportability given to the obtained thin film, the type and boiling point of solvent, etc., but when the obtained thin film is used as a hole injection layer for an organic EL device, the baking temperature is preferably about 140 to 250°C, more preferably about 145 to 240°C. In particular, because the composition of the present invention has a feature that it can be baked at a low temperature of 200°C or lower, a thin film having excellent charge transportability can be provided even when baked at a relatively low temperature.

Note that, during baking, for the purpose of expressing a higher uniform film formation property or advancing the reaction on a substrate, the temperature may be changed in two or more steps, and heating may be performed, for example, using an appropriate device such as a hot plate or an oven.

The charge-transporting thin film is not particularly limited for film thickness, but when used as a hole injection layer in an organic EL device, the film thickness is preferably 5 to 200 nm. The method for changing the film thickness includes a method including changing the solid content concentration in the composition or a method including changing the amount of solution on a substrate at the time of application.

The organic EL device of the present invention has a pair of electrodes, and has the charge-transporting thin film of the present invention between these electrodes.

Typical configurations of the organic EL device include, but are not limited to, the following (a) to (f). In the following configurations, if necessary, the electron block layer or the like may be provided between the light emitting layer and the anode, and the hole block layer or the like may be provided between the light emitting layer and the cathode. In addition, the hole injection layer, the hole transport layer, or the hole injection transport layer may also have a function as the electron block layer or the like, and the electron injection layer, the electron transport layer, or the electron injection transport layer may also have a function as the hole block layer or the like. Furthermore, it is also possible to provide any functional layer between the respective layers, if necessary.
(a) Anode/hole injection layer/hole transport layer/light emitting layer/electron injection layer/electron transport layer/cathode
(b) Anode/hole injection layer/hole transport layer/light emitting layer/electron injection transport layer/cathode
(c) Anode/hole injection transport layer/light emitting layer/electron injection layer/electron transport layer/cathode
(d) Anode/hole injection transport layer/light emitting layer/electron injection transport layer/cathode
(e) Anode/hole injection layer/hole transport layer/light emitting layer/cathode
(f) Anode/hole injection transport layer/light emitting layer/cathode

As to the "hole injection layer", "hole transport layer" and "hole injection transport layer", a layer is the "hole injection transport layer" formed between the light emitting layer and the anode, having the function of transporting holes from the anode to the light emitting layer, and having only one layer of hole transporting material provided between the light emitting layer and the anode, a layer is the "hole injection layer" close to the anode when two or more layers of hole transporting material are provided between the light emitting layer and the anode, and the other layer is the "hole transport layer". In particular, as the hole injection (transport) layer, a thin film is used excellent in not only hole acceptability from the anode but also hole injection property into the hole transport (light emitting) layer.

As to the "electron injection layer", "electron transport layer" and "electron injection transport layer", a layer is the "electron injection transport layer" formed between the light emitting layer and the cathode, having the function of transporting electrons from the cathode to the light emitting layer, and having only one layer of electron transporting material provided between the light emitting layer and the cathode, a layer is the "electron injection layer" close to the cathode when two or more layers of electron transporting material are provided between the light emitting layer and the cathode, and the other layer is the "electron transport layer".

The "light emitting layer" is an organic layer having a light emitting function, and contains a host material and a dopant material when a doping system is adopted. In this case, the host material mainly has a function of promoting a recombination of electrons and holes and confining excitons in the light emitting layer, and the dopant material has a function of efficiently emitting light by the excitons obtained by the recombination. In the case of a phosphorescent device, the host material mainly has a function of confining excitons generated by the dopant in the light emitting layer.

The charge-transporting thin film of the present invention may be used as the hole injection layer, hole transport layer and hole injection transport layer in an organic EL device, suitably used for the hole injection layer.

The materials used and methods for producing an EL device using the composition for forming a charge-transporting thin film of the present invention include, but are not limited to, the following.

An example of the method for producing an OLED device having the hole injection layer made of a thin film obtained from the composition for forming a charge-transporting thin film of the present invention is as follows. Note that it is preferable that electrodes be preliminarily cleaned with alcohol, pure water or the like, or surface-treated by UV ozone treatment, oxygen-plasma treatment or the like, without adversely affecting the electrodes.

The hole injection layer made of the charge-transporting thin film of the present invention is formed on an anode substrate by the above method. The formed hole injection layer thereon is introduced into a vacuum vapor deposition apparatus, and the hole transport layer, light emitting layer, electron transport layer, electron transport layer/hole block layer and cathode metal are sequentially vapor-deposited. Alternatively, instead of forming the hole transport layer and light emitting layer by vapor deposition in the method, these layers are formed by a wet process using a composition for forming a hole transport layer containing a hole transporting polymer and a composition for forming a light emitting layer containing a light emitting polymer. If necessary, the electron blocking layer may be provided between the light emitting layer and the hole transport layer.

The anode material includes transparent electrodes typified by indium tin oxide (ITO) or indium zinc oxide (IZO), and metal anodes composed of metals typified by aluminum, alloys of them or the like, and those that have been flattened are preferable. A polythiophene derivative or a polyaniline derivative having a high charge transportability can also be used.

Another metal composing the metal anode includes, but is not limited to, gold, silver, copper, indium, and alloys thereof.

The material for forming the hole transport layer includes (triphenylamine) dimer derivatives, a [(triphenylamine)dimer]spirodimer, N,N'-bis(naphthalen-1-yl)-N,N'-bis(phenyl)-benzidine (a-NPD), triarylamines such as 4,4',4"-tris[3-methylphenyl(phenyl)amino]triphenylamine (m-MTDATA) and 4,4',4"-tris[I-naphthyl(phenyl)amino]triphenylamine (1-TNATA), and oligothiophenes such as 5,5"-bis-{4-[bis(4-methylphenyl)amino]phenyl}-2,2':5',2"-terthiophene (BMA-3T).

The material for forming the light emitting layer includes, but is not limited to, low molecular weight light emitting materials such as metal complexes such as an aluminum complex of 8-hydroxyquinoline, metal complexes of 10-hydroxybenzo[h]quinoline, bisstyrylbenzene derivatives, bisstyrylallylene derivatives, metal complexes of (2-hydroxyphenyl)benzothiazole and silole derivatives; and systems in which a light emitting material and an electron transfer material are mixed with a high molecular compound such as poly(p-phenylene vinylene), poly[2-methoxy-5-(2-ethylhexyloxy)-1,4-phenylene vinylene], poly(3-alkylthiophene) or polyvinylcarbazole.

When forming the light emitting layer by vapor deposition, a light emitting dopant may be co-deposited. The light emitting dopant includes, but is not limited to, metal complexes such as tris(2-phenylpyridine)iridium (III) (Ir(ppy)₃), naphthacene derivatives such as rubrene, quinacridone derivatives and condensed polycyclic aromatic rings such as perylene.

The material for forming the electron transport layer/hole block layer includes, but is not limited to, oxydiazole derivatives, triazole derivatives, phenanthroline derivatives, phenylquinoxaline derivatives, benzimidazole derivatives and pyrimidine derivatives.

The material for forming the electron injection layer includes, but is not limited to, metal oxides such as lithium oxide (Li₂O), magnesium oxide (MgO) and alumina (Al₂O₃), and metal fluorides such as lithium fluoride (LiF) and sodium fluoride (NaF).

The cathode material includes, but is not limited to, aluminum, a magnesium-silver alloy and an aluminum-lithium alloy.

The material for forming the electron block layer includes, but is not limited to, tris(phenylpyrazole)iridium.

The hole transporting polymer includes poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-pentene-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)-benzidine]-endcapped with polysilsesquioxane and poly[(9,9-didioctylfluorenyl-2,7-diyl)-co-(4,4'-(N-(p-butylphenyl))diphenylamine)].

The light emitting polymer includes polyfluorene derivatives such as poly(9,9-dialkylfluorene) (PDAF), polyphenylene vinylene derivatives such as poly(2-methoxy-5-(2'-ethylhexoxy)-1,4-phenylene vinylene) (MEH-PPV), polythiophene derivatives such as poly(3-alkylthiophene) (PAT) and polyvinylcarbazole (PVCz).

As described above, the composition for forming a charge-transporting thin film of the present invention is suitably used to form the hole injection layer or the hole transport layer of organic EL devices. Besides, the charge-transporting composition can also be used to form the charge-transporting thin film in electronic devices such as organic photoelectric conversion devices, organic thin film solar cells, organic perovskite photoelectric conversion devices, organic integrated circuits, organic field effect transistors, organic thin film transistors, organic light emitting transistors, organic optical inspection devices, organic photoreceptors, organic electric field quenchers, luminescent electrochemical cells, quantum dot light emitting diodes, quantum lasers, organic laser diodes and organic plasmon light emitting devices.

### EXAMPLES

Hereinafter, a specific description is made of the present invention with reference to Examples and Comparative Examples, but the present invention is not limited to the following Examples. The equipment used is as follows.
(1) ¹H-NMR :
   Nuclear magnetic resonance spectrometer AVANCE III HD 500 MHz manufactured by Bruker Corporation
(2) Substrate cleaning:
   Substrate cleaning apparatus (reduced pressure plasma type) manufactured by Choshu Industry Co., Ltd.
(3) Application of composition:
   Spin Coater MS-A100 manufactured by Mikasa Co., Ltd.
(4) Measurement of film thickness:
   fine shape measuring machine Surf Coder ET-4000 manufactured by Kosaka Laboratory Ltd.
(5) Production of EL device:
   Multi-function vapor deposition apparatus System C-E2L1G1-N manufactured by Choshu Industry Co., Ltd.
(6) Measurement of current density and the like of EL element:
   Multi-channel IVL measuring apparatus manufactured by EHC Co., Ltd.

### [1] Synthesis of compound

### [Example of Synthesis 1] Synthesis of aryl sulfonate

The aryl sulfonate S represented by the following formula was synthesized in accordance with WO 2017/217455.

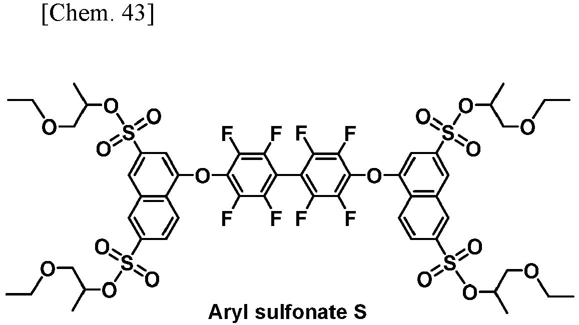

### [Example of Synthesis 2] Synthesis of aniline derivatives A, B and C

The following aniline derivatives A and B were synthesized in accordance with the methods described in Production Examples 11 and 9 in WO 2015/050253, respectively.

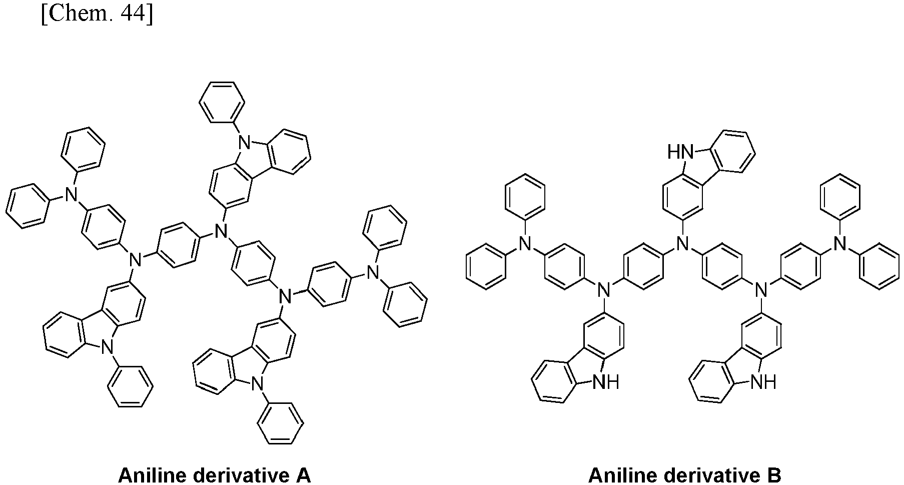

The aniline derivative C was synthesized by the following method.

To a suspension of the aniline derivative B (1.18 g, 1 mmol) in THF (tetrahydrofuran) (25 mL) were added di-t-butyl dicarbonate (982 mg, 4.5 mmol) and 4-dimethylaminopyridine (367 mg, 3 mmol). The resulting mixture was stirred at room temperature for 3 hours.

Then, the reaction solution was added dropwise to methanol (125 mL), and the precipitated solid was collected by filtration and dried to yield an aniline derivative C (1.46 g). The measurement results by ¹H-NMR are shown below.
¹H-NMR (500 MHz, THF-d₈) δ [ppm] :
1.78 (s, 27H), 6.95-7.01 (m, 8H), 7.05-7.09 (m, 20H), 7.22-7.25 (m, 8H), 7.29-7.32 (m, 6H), 7.45 (dd, J = 7.5, 8.5 Hz, 3H), 7.89 (d, J = 2.0 Hz, 3H), 7.98 (d, J = 7.5 Hz, 3H), 8.25 (d, J = 9.0 Hz, 3H), 8.34 (d, J = 8.5 Hz ,3H).

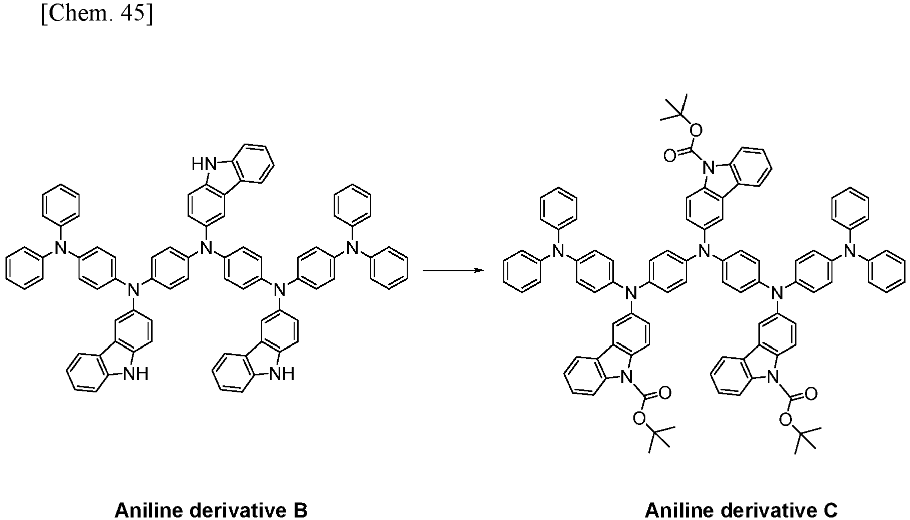

### [Example of Synthesis 3] Synthesis of aniline derivatives D and E

### (1) Synthesis of compound 1

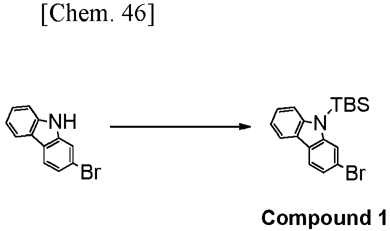

To a 60% suspension of sodium hydride (4.8 g, 120 mmol) in THF (150 mL) was added dropwise a solution of 2-bromocarbazole (24.6 g, 100 mmol) in THF (200 mL) under ice-cooling, followed by stirring at room temperature for 30 minutes. Under ice-cooling, a solution of tert-butyldimethylsilyl chloride (18.1g, 120 mmol) in THF (40 mL) was added dropwise, followed by stirring at room temperature for 2 hours. Water (66 mL) was added, followed by extraction 3 times with ethyl acetate (50 mL). The resulting product was dried over magnesium sulfate and subjected to filtration, and the solvent was distilled off to yield a light brown solid. Hexane (150 mL) was added, followed by filtration. To the resulting product was added methanol (333 mL), followed by reflux for 30 minutes. Then, the mixture was cooled to room temperature and subjected to filtration to yield a compound 1 as a white solid (27.1 g, yield: 75%). The measurement results by ¹H-NMR are shown below.
¹H-NMR (500 MHz, CDCL₃) δ [ppm]:
0.75 (s, 6H), 1.04 (s, 9H), 7.24 (t, J = 7.5 Hz, 1H), 7.34 (d, J = 8.0 Hz, 1H), 7.38 (t, J = 7.5 Hz,1H), 7.59 (d, J = 8.5 Hz, 1H), 7.73 (s, 1H), 7.90 (d, J = 8.5 Hz, 1H), 8.02 (d, J = 7.5 Hz, 1H).

### (2) Synthesis of compound 2

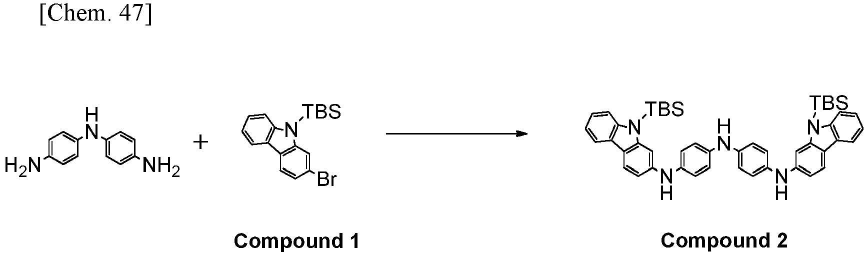

To a solution of 4,4'-diaminodiphenylamine (3 g, 15 mmol) and the compound 1 (11.1 g, 30.75 mmol) in toluene (60 mL) were added Pd(dba)₂ (173 mg, 0.3 mmol), [(t-Bu)₃PH]BF₄ (174 mg, 0.6 mmol) and t-BuONa (3.17 g, 33 mmol), followed by heating and stirring at 80°C for 2 hours. After washing with saturated brine (60 mL), the mixture was dried over sodium sulfate and subjected to filtration. Then, the solvent was distilled off, followed by purification by column chromatography to yield a Compound 2 as a white solid (3.6 g, yield: 32%). The measurement results by ¹H-NMR are shown below.
¹H-NMR (500 MHz, DMSO-d₆) δ [ppm]:
0.67 (s, 12H), 0.96 (s, 18H), 6.85 (d, J = 8.5 Hz, 2H), 7.02 (d, J = 8.5 Hz, 4H), 7.08 (d, J = 8.5 Hz, 4H), 7.11 (t, J = 7.5 Hz, 2H), 7.18-7.22 (m, 4H), 7.53 (d, J = 8.0 Hz, 2H), 7.76 (brs, 1H), 7.87 (d, J = 8.5 Hz, 2H), 7.90 (d, J = 7.5 Hz, 2H), 7.96 (brs, 2H).

### (3) Synthesis of compound 3

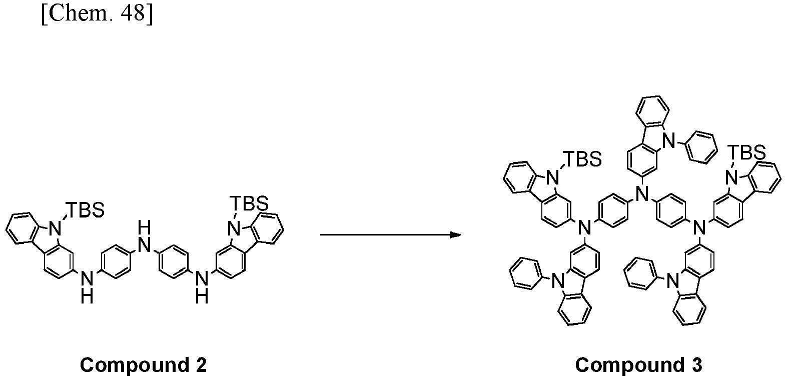

To a solution of the compound 2 (3.45 g, 4.56 mmol) and 2-bromo-9-phenylcarbazole (4.63 g, 14.36 mmol) in toluene (35 mL) were add Pd(dba)₂ (155 mg, 0.27 mmol), [(t-Bu)₃PH]BF₄ (160 mg, 0.55 mmol) and t-BuONa (1.84 g, 19.15 mmol), followed by heating and stirring at 90°C for 2 hours. After washing with a saturated salt solution (35 mL) and passing through silica gel (90 g), toluene (520 mL) was further flowed through the silica gel. The obtained solution was concentrated to 140 g, and then added dropwise to an ethyl acetate (260 mL)/methanol (780 mL) mixed solution, followed by stirring at room temperature for 2 hours. The precipitated solid was subjected to filtration to yield a compound 3 as a yellow solid (5.35 g, yield: 79%). The measurement results by ¹H-NMR are shown below.
¹H-NMR (500 MHz, THF-d₈) δ [ppm]:
0.50 (s, 12H), 0.86 (s, 18H), 7.03-7.08 (m, 15H), 7.11-7.21 (m, 8H), 7.26-7.34 (m, 10H), 7.42-7.58 (m, 15H), 7.88 (d, J = 8.5 Hz, 2H), 7.92 (d, J = 7.5 Hz, 2H), 8.00-8.06 (m, 6H).

### (4) Synthesis of aniline derivative D

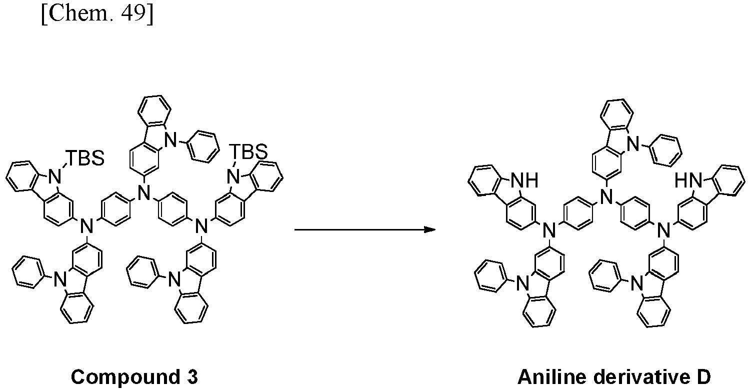

To a solution of the Compound 3 (5.28 g, 3.56 mmol) in THF (25 mL) was added dropwise a 1 mol/L tetrabutylammonium fluoride/THF solution (10.7 mL, 10.7 mmol) under ice-cooling, followed by stirring at room temperature for 2 hours. The reaction solution was added dropwise to methanol (90 mL), and the precipitated solid was subjected to filtration to yield an aniline derivative D as a yellow solid (4.16 g, yield: 93%). The measurement results by ¹H-NMR and MALDI-TOF-MS are shown below.
¹H-NMR (500 MHz, THF-d₈) δ [ppm]:
6.96-7.12 (m, 17H), 7.17-7.35 (m, 18H), 7.41-7.60 (m, 13H), 7.89-7.94 (m, 4H), 7.99-8.05 (m, 6H), 10.00 (brs, 2H).
MALDI-TOF-MS m/Z found:
1253.52 ([M+H]⁺calcd: 1253.49)

### (5) Synthesis of aniline derivative E

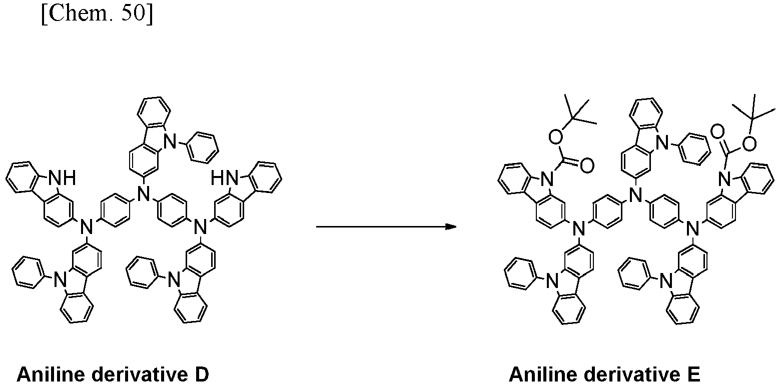

To a suspension of the aniline derivative D (1.25 g, 1 mmol) in THF (25 mL) were added di-t-butyl dicarbonate (655 mg, 3 mmol) and 4-dimethylaminopyridine (244 mg, 2 mmol). The resulting mixture was stirred at room temperature for 3 hours.

Then, the reaction solution was added dropwise to methanol (125 mL), and the precipitated solid was collected by filtration and dried to yield an aniline derivative E (1.38 g, yield: 95%). The measurement results by ¹H-NMR are shown below.
¹H-NMR (500 MHz, THF-d₈) δ [ppm]:
1.41 (s, 18H), 7.06-7.13 (m, 12H), 7.19-7.35 (m, 19H), 7.43-7.61 (m, 13H), 7.84 (d, J = 8.5 Hz, 2H), 7.90 (d, J = 7.5 Hz, 2H), 8.02-8.07 (m, 8H), 8.30 (d, J = 8.5 Hz, 2H).

### [2] Preparation of composition for forming charge-transporting thin film (selection of solvent for preparing composition)

### [Example 1-1]

The aniline derivative C (0.526 g) was added to cyclohexylbenzene (10 g), which was an aromatic hydrocarbon-based solvent, followed by heating and stirring. As a result, the aniline derivative C was completely dissolved to yield a composition C1.

### [Example 1-2]

The aniline derivative C (0.526 g) was added to a mixed solvent composed of butyl benzoate (7 g) and 3-phenoxytoluene (3 g), which was a low-polarity solvent containing a polar group, followed by heating and stirring. As a result, the aniline derivative C was completely dissolved to yield a composition C2.

### [Example 1-3]

The aniline derivative C (0.526 g) was added to a mixed solvent composed of 1,3-dimethyl-2-imidazolidinone (7 g), 2,3-butanediol (2 g) and dipropylene glycol monomethyl ether (1 g), which was a high-polarity solvent containing a polar group, followed by heating and stirring. As a result, the aniline derivative C was completely dissolved to yield a composition C3.

### [Example 1-4]

The aniline derivative E (0.526 g) was added to cyclohexylbenzene (10 g), followed by heating and stirring. As a result, the aniline derivative E was completely dissolved to yield a composition E1.

### [Example 1-5]

The aniline derivative E (0.526 g) was added to a mixed solvent composed of butyl benzoate (7 g) and 3-phenoxytoluene (3 g), followed by heating and stirring. As a result, the aniline derivative E was completely dissolved to yield a composition E2.

### [Example 1-6]

The aniline derivative E (0.526 g) was added to a mixed solvent composed of 1,3-dimethyl-2-imidazolidinone (7 g), 2,3-butanediol (2 g) and dipropylene glycol monomethyl ether (1 g), followed by heating and stirring. As a result, the aniline derivative E was completely dissolved to yield a composition E3.

### [Comparative Example 1-1]

The aniline derivative A (0.526 g) was added to cyclohexylbenzene (10 g), which was an aromatic hydrocarbon-based solvent, followed by heating and stirring. As a result, the aniline derivative A was completely dissolved to yield a composition A1.

### [Comparative Example 1-2]

The aniline derivative A (0.526 g) was added to a mixed solvent composed of butyl benzoate (7 g) and 3-phenoxytoluene (3 g), followed by heating and stirring. As a result, the aniline derivative A was completely dissolved to yield a composition A2.

### [Comparative Example 1-3]

The aniline derivative A (0.526 g) was added to a mixed solvent composed of 1,3-dimethyl-2-imidazolidinone (7 g), 2,3-butanediol (2 g) and dipropylene glycol monomethyl ether (1 g), followed by heating and stirring. As a result, the aniline derivative A was completely dissolved to yield a composition A3.

### [Comparative Example 1-4]

The aniline derivative B (0.526 g) was added to cyclohexylbenzene (10 g), which was an aromatic hydrocarbon-based solvent, followed by heating and stirring. As a result, the aniline derivative B was not completely dissolved.

### [Comparative Example 1-5]

The aniline derivative B (0.526 g) was added to a mixed solvent composed of butyl benzoate (7 g) and 3-phenoxytoluene (3 g), followed by heating and stirring. As a result, the aniline derivative B was not completely dissolved.

### [Comparative Example 1-6]

The aniline derivative B (0.526 g) was added to a mixed solvent composed of 1,3-dimethyl-2-imidazolidinone (7 g), 2,3-butanediol (2 g) and dipropylene glycol monomethyl ether (1 g), followed by heating and stirring. As a result, the aniline derivative B was completely dissolved to yield a composition B3.

### [Comparative example 1-7]

The aniline derivative D (0.526 g) was added to cyclohexylbenzene (10 g), which was an aromatic hydrocarbon-based solvent, followed by heating and stirring. As a result, the aniline derivative D was not completely dissolved.

### [Comparative Example 1-8]

The aniline derivative D (0.526 g) was added to a mixed solvent composed of butyl benzoate (7 g) and 3-phenoxytoluene (3 g), followed by heating and stirring. As a result, the aniline derivative D was completely dissolved to yield a composition D2.

### [Comparative Example 1-9]

The aniline derivative D (0.526 g) was added to a mixed solvent composed of 1,3-dimethyl-2-imidazolidinone (7 g), 2,3-butanediol (2 g) and dipropylene glycol monomethyl ether (1 g), followed by heating and stirring. As a result, the aniline derivative D was completely dissolved to yield a composition D3.

Table 1 summarizes the results of Examples 1-1 to 1-6 and Comparative Examples 1-1 to 1-9. From these results, the following has been confirmed.

The aniline derivative C and the aniline derivative E used in the Examples exhibited good solubility in both high-polarity solvent and low-polarity solvent. Also, the aniline derivative A used in the Comparative Example exhibited good solubility in both high-polarity solvent and low-polarity solvent.

On the other hand, the aniline derivative B used in the Comparative Example was dissolved in a high-polarity solvent, but was not completely dissolved in a low-polarity solvent. Also, the aniline derivative D used in the Comparative Example was dissolved in a high-polarity solvent and a low-polarity solvent having a polar group, but was not completely dissolved in a low-polarity solvent free of a polar group.

**[Table 1]**

| | Composition | Aniline derivative | Description of solvent used | Solubility |
|---|---|---|---|---|
| Example 1-1 | C1 | Aniline derivative C | Low-polarity free of polar group | ○ |
| Example 1-2 | C2 | Aniline derivative C | Low-polarity having polar group | ○ |
| Example 1-3 | C3 | Aniline derivative C | High-polarity | ○ |
| Example 1-4 | E1 | Aniline derivative E | Low-polarity free of polar group | ○ |
| Example 1-5 | E2 | Aniline derivative E | Low-polarity having polar group | ○ |
| Example 1-6 | E3 | Aniline derivative E | High-polarity | ○ |
| Comparative Example 1-1 | A1 | Aniline derivative A | Low-polarity free of polar group | ○ |
| Comparative Example 1-2 | A2 | Aniline derivative A | Low-polarity having polar group | ○ |
| Comparative Example 1-3 | A3 | Aniline derivative A | High-polarity | ○ |
| Comparative Example 1-4 | - | Aniline derivative B | Low-polarity free of polar group | × |
| Comparative Example 1-5 | - | Aniline derivative B | Low-polarity having polar group | × |
| Comparative Example 1-6 | B3 | Aniline derivative B | High-polarity | ○ |
| Comparative Example 1-7 | - | Aniline derivative D | Low-polarity free of polar group | × |
| Comparative Example 1-8 | D2 | Aniline derivative D | Low-polarity having polar group | ○ |
| Comparative Example 1-9 | D3 | Aniline derivative D | High-polarity | ○ |

### [3] Preparation of composition for forming charge-transporting thin film

### [Example 2-1]

To a mixed solvent composed of 3-phenoxytoluene (3 g) and butyl benzoate (7 g) were added the aniline derivative C (0.155 g) and aryl sulfonate S (0.261 g), followed by heating and stirring to prepare a composition for forming a charge-transporting thin film C4.

### [Example 2-2]

In a mixed solvent composed of 1,3-dimethyl-2-imidazolidinone (7 g), 2,3-butanediol (2 g) and dipropylene glycol monomethyl ether (1 g) was dissolved the aryl sulfonate S (0.261 g) and then added the aniline derivative C (0.155 g), followed by heating and stirring to prepare a composition for forming a charge-transporting thin film C5.

### [Example 2-3]

In a mixed solvent composed of 3-phenoxytoluene (3 g) and butyl benzoate (7 g) was dissolved the aryl sulfonate S (0.263 g) and then added the aniline derivative E (0.153 g), followed by heating and stirring to prepare a composition for forming a charge-transporting thin film E4.

### [Example 2-4]

In a mixed solvent composed of 1,3-dimethyl-2-imidazolidinone (7 g), 2,3-butanediol (2 g) and dipropylene glycol monomethyl ether (1 g) was dissolved the aryl sulfonate S (0.263 g) and then added the aniline derivative E (0.153 g), followed by heating and stirring to prepare a composition for forming a charge-transporting thin film E5.

### [Comparative Example 2-1]

To a mixed solvent composed of 3-phenoxytoluene (3 g) and butyl benzoate (7 g) were added the aniline derivative A represented by the following formula (0.151 g) and aryl sulfonate S (0.266 g), followed by heating and stirring to prepare a composition for forming a charge-transporting thin film A4.

### [Comparative Example 2-2]

In a mixed solvent composed of 1,3-dimethyl-2-imidazolidinone (7 g), 2,3-butanediol (2 g) and dipropylene glycol monomethyl ether (1 g) was dissolved the aryl sulfonate S (0.266 g) and then added the aniline derivative A (0.151 g), followed by heating and stirring to prepare a composition for forming a charge-transporting thin film A5.

### [Comparative Example 2-3]

To a mixed solvent composed of 3-phenoxytoluene (3 g) and butyl benzoate (7 g) were added the aniline derivative B (0.134 g) and aryl sulfonate S (0.283 g), followed by stirring to make an attempt to prepare a composition for forming a charge-transporting thin film B4. However, they were not completely dissolved so that the composition was not obtained that could be used to form a thin film.

### [Comparative Example 2-4]

In a mixed solvent composed of 1,3-dimethyl-2-imidazolidinone (7 g), 2,3-butanediol (2 g) and dipropylene glycol monomethyl ether (1 g) was dissolved the aryl sulfonate S (0.283 g) and then added the aniline derivative B (0.134 g), followed by heating and stirring to prepare a composition for forming a charge-transporting thin film B5.

Table 2 summarizes the composition for forming a charge-transporting thin film prepared in the Examples and Comparative Examples. From the results shown in Table 2, the following has been confirmed.

In Examples 2-1 to 2-4, the aniline derivative used exhibited good solubility in both high-polarity and low-polarity solvents, confirming that a uniform composition for forming a charge-transporting thin film was obtained.

Similarly to the Embodiments, for Comparative Examples 2-1 and 2-2 (in which an aniline derivative having a phenyl group on the nitrogen atom of a carbazole group was used), the aniline derivative exhibited good solubility in both high-polarity and low-polarity solvents, confirming that a uniform composition for forming a charge-transporting thin film was obtained.

On the other hand, for Comparative Examples 2-3 and 2-4 (in which an aniline derivative free of a substituent on the nitrogen atom of a carbazole group was used), the aniline derivative used was dissolved in a high-polarity solvent, but was not completely dissolved in a low-polarity solvent, confirming that applicable organic solvents were limited.

**[Table 2]**

| | Composition | Aniline derivative | Solvent species of composition | Solubility |
|---|---|---|---|---|
| Example 2-1 | C4 | Aniline derivative C | Low-polarity | ○ |
| Example 2-2 | C5 | Aniline derivative C | High-polarity | ○ |
| Example 2-3 | E4 | Aniline derivative E | Low-polarity | ○ |
| Example 2-4 | E5 | Aniline derivative E | High-polarity | ○ |
| Comparative Example 2-1 | A4 | Aniline derivative A | Low-polarity | ○ |
| Comparative Example 2-2 | A5 | Aniline derivative A | High-polarity | ○ |
| Comparative Example 2-3 | B4 | Aniline derivative B | Low-polarity | × |
| Comparative Example 2-4 | B5 | Aniline derivative B | High-polarity | ○ |

### [4] Preparation and characterization of single-layer device (SLD)

In the following Examples and Comparative Examples, as an ITO substrate, a 25 mm × 25 mm × 0.7 t glass substrate having ITO patterned on the surface with a film thickness of 150 nm was used. Before use, an O₂ plasma cleaning apparatus was used (150 W, for 30 seconds) to remove impurities on the surface.

### [Example 3-1]

The composition for forming a charge-transporting thin film C4 obtained in Example 2-1 was applied to the ITO substrate using a spin coater, then preliminarily baked at 120°C for 1 minute in the air, and subsequently mainly baked at 200°C for 15 minutes to form a 50 nm thin film on the ITO substrate.

On the thin film was formed an aluminum thin film using a vapor deposition apparatus (vacuum degree of 4.0×10⁻⁵ Pa) to prepare an SLD. The vapor deposition was performed under the condition of a vapor deposition rate of 0.2 nm/sec. The film thickness of the aluminum thin film was 80 nm.

In order to prevent deterioration of characteristics due to the influence of oxygen, water, etc. in the air, the SLD was sealed with sealing substrates and then its characteristics were evaluated. The sealing was performed by the following procedure.

In a nitrogen atmosphere with an oxygen concentration of 2 ppm or less and a dew point of -85°C or less, the SLD was placed between the sealing substrates, and the sealing substrates were bonded to each other with an adhesive (Moresco Moisture Cut WB90US (P), manufactured by MORESCO Corporation). At this time, a water catching agent (HD-071010W-40 manufactured by DYNIC Corporation) was contained in the sealing substrates together with the SLD. The bonded sealing substrates were irradiated with UV light (wavelength of 365 nm, irradiation dose of 6,000 mJ/cm²) and then annealed at 80°C for 1 hour to cure the adhesive.

### [Examples 3-2 to 3-4 and Comparative Examples 3-1 to 3-3]

SLDs were produced in the same manner as in Example 3-1 except that the compositions for forming a charge-transporting thin film C2, E1, E2, A1, A2 and B2 obtained in Examples 2-2 to 2-4 and Comparative Examples 2-1, 2-2 and 2-4, respectively, were used instead of the composition for forming a charge-transporting thin film C4 obtained in Example 2-1.

For each SLD produced in the Examples and Comparative Examples, the current density at a drive voltage of 3 V was measured. The results are shown in Table 3.

**[Table 3]**

| | Composition | Current density (mA/cm²) |
|---|---|---|
| Example 3-1 | C4 | 4,550 |
| Example 3-2 | C5 | 4,490 |
| Comparative Example 3-1 | A4 | 4,130 |
| Comparative Example 3-2 | A5 | 3,700 |
| Comparative Example 3-3 | B5 | 4,200 |
| Example 3-3 | E4 | 1,790 |
| Example 3-4 | E5 | 2,080 |

From the results in Table 3, a thin film obtained from the composition containing a charge-transporting substance precursor having a 9-t-butoxycarbonyl carbazole structure in the molecule exhibits high hole transportability, as compared with a thin film obtained from a composition containing a charge transporting substance that is free of such a 9-t-butoxycarbonyl carbazole structure, but, for example, has a carbazole structure having a hydrogen atom instead of 9-t-butoxycarbonyl at the N-position.

### [5] Preparation and characterization of hole only device (HOD)

In the following Examples and Comparative Examples, the same ITO substrate as described above was used.

### [Example 4-1]

The composition for forming a charge-transporting thin film C4 obtained in Example 2-1 was applied to the ITO substrate using a spin coater, then preliminarily baked at 120°C for 1 minute in the air, and subsequently mainly baked at 200°C for 15 minutes to form a 50 nm thin film on the ITO substrate.

On the thin film were sequentially laminated α-NPD and an aluminum thin film using a vapor deposition apparatus (vacuum degree of2.0×10⁻⁵ Pa) to prepare an HOD. The vapor deposition was performed under the condition of a vapor deposition rate of 0.2 nm/sec. The film thicknesses of the thin films of α-NPD and aluminum were 30 nm and 80 nm, respectively.

In order to prevent deterioration of characteristics due to the influence of oxygen, water, etc. in the air, the HOD was sealed with sealing substrates and then its characteristics were evaluated. The sealing was performed by the following procedure.

In a nitrogen atmosphere with an oxygen concentration of 10 ppm or less and a dew point of -75°C or less, the HOD was placed between the sealing substrates, and the sealing substrates were bonded to each other with an adhesive (Moresco Moisture Cut WB90US (P), manufactured by MORESCO Corporation). At this time, a water catching agent (HD-071010W-40 manufactured by DYNIC Corporation) was contained in the sealing substrates together with the HOD. The bonded sealing substrates were irradiated with UV light (wavelength of 365 nm, irradiation dose of 6,000 mJ/cm²) and then annealed at 80°C for 1 hour to cure the adhesive.

### [Examples 4-2 to 4-4 and Comparative Examples 4-1 to 4-2]

HODs were produced in the same manner as in Example 3-1 except that the compositions for forming a charge-transporting thin film C5, E4, E5, A4, A5 and B5 obtained in Examples 2-2 to 2-4 and Comparative Examples 2-1 and 2-4, respectively, were used instead of the composition for forming a charge-transporting thin film C4.

For each HOD produced in the Examples and Comparative Examples, the current density at a drive voltage of 3 V was measured. The results are shown in Table 4.

**[Table 4]**

| | Composition | Current density (mA/cm²) |
|---|---|---|
| Example 4-1 | C4 | 1,300 |
| Example 4-2 | C5 | 1,410 |
| Comparative Example 4-1 | A4 | 850 |
| Comparative Example 4-2 | A5 | 870 |
| Example 4-3 | E4 | 542 |
| Example 4-4 | E5 | 464 |

From the results in Table 4, a thin film obtained from the composition containing a charge-transporting substance precursor having a 9-t-butoxycarbonyl carbazole structure in the molecule exhibits excellent hole injection property into α-NPD which is often used as a hole transport layer, as compared with a thin film obtained from a composition containing a charge transporting substance that is free of such a 9-t-butoxycarbonyl carbazole structure, but, for example, has a carbazole structure having a hydrogen atom instead of 9-t-butoxycarbonyl at the N-position.

### [Example 5-1]

The composition for forming a hole injection layer obtained by the method described later was applied by spin coating, heated to 80°C on a hot plate in the air, dried for 1 minute, and then further heated and baked at 230°C for 15 minutes to form a charge-transporting thin film (film thickness: 30 nm) as a hole injection layer.

Next, the composition for forming a charge-transporting thin film C1 obtained in Example 1-1 was applied on the hole injection layer using a spin coater, and then baked at 200°C for 15 minutes in the air atmosphere to form a charge-transporting thin film as a 40 nm hole transport layer.

On this, an 80 nm aluminum thin film was formed at 0.2 nm/sec using a vapor deposition apparatus (vacuum degree of 1.0 × 10⁻⁵ Pa) to prepare a hole-only element (HOD).

The composition for forming a hole injection layer was prepared by the following procedure. In 6.7 g of 1,3-dimethyl-2-imidazolidinone were dissolved 0.137 g of the aniline derivative represented by the formula (3) synthesized in accordance with the method described in WO 2013/084664, and 0.271 g of the aryl sulfonic acid represented by the formula (4) synthesized in accordance with the method described in WO 2006/025342 under a nitrogen atmosphere. To the obtained solution, 10 g of cyclohexanol and 3.3 g of propylene glycol were sequentially added, followed by stirring to yield a composition for forming a hole injection layer (the same applies hereinafter).

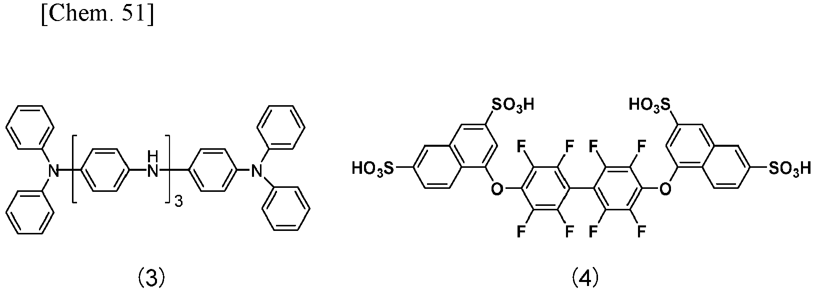

### [Examples 5-2 and Comparative Examples 5-1 to 5-2]

HODs were produced in the same manner as in Example 5-1 except that the compositions for forming a charge-transporting thin film E1, A1 and D2 obtained in Examples 1-4 and Comparative Examples 1-1 and 1-8, respectively, were used instead of the composition for forming a charge-transporting thin film C1. When the composition for forming a charge-transporting thin film A3, B3, C3, D3 or E3 containing a high-polarity solvent was used, it was not possible to produce an HOD allowing for evaluation of the electrical characteristics because the lower hole injection layer was damaged in all cases.

For each of the HODs produced in the Examples and Comparative Examples, the current density at a drive voltage of 4 V was measured. The results are shown in Table 5.

**[Table 5]**

| | Composition | Current density (mA/cm²) |
|---|---|---|
| Example 5-1 | C1 | 2,820 |
| Example 5-2 | E1 | 1,140 |
| Comparative Example 5-1 | A1 | 995 |
| Comparative Example 5-2 | D2 | 446 |

From the results in Table 5, it has been confirmed that a thin film obtained from the composition containing a charge-transporting substance precursor having a 9-t-butoxycarbonyl carbazole structure in the molecule well serves a function also as a hole transport layer, as compared with a thin film obtained from a composition containing a charge transporting substance that is free of such a 9-t-butoxycarbonyl carbazole structure, but, for example, has a carbazole structure having a hydrogen atom instead of 9-t-butoxycarbonyl at the N-position.

## Claims

1. A composition for forming a charge-transporting thin film, comprising: a charge-transporting substance precursor having in its molecule a 9-t-butoxycarbonyl carbazole structure; and an organic solvent.

2. The composition for forming a charge-transporting thin film according to claim 1, further comprising a dopant substance.

3. A charge-transporting thin film, obtained from the composition for forming a charge-transporting thin film according to claim 1 or 2.

4. An electronic device having the charge-transporting thin film according to claim 3.

5. An organic electroluminescence device having the charge-transporting thin film according to claim 3.

6. The organic electroluminescence device according to claim 5, wherein the charge-transporting thin film is a hole injection layer or a hole transport layer.

7. A method for producing a charge-transporting thin film, the method comprising applying the composition for forming a charge-transporting thin film according to claim 1 or 2 on a substrate, and baking the composition to desorb a 9-t-butoxycarbonyl group from the charge-transporting substance precursor.
